# EUROPÄISCHE PATENTSCHRIFT

(11) **EP 2 714 841 B1**
(45) Veröffentlichungstag und Bekanntmachung des Hinweises auf die Patenterteilung: **22.06.2016**
(21) Anmeldenummer: 12722074.7
(22) Anmeldetag: 07.05.2012
(51) Int. Cl.: C09K 11/06, H01L 51/00, H01L 51/50

(54) **ORGANISCHE ELEKTROLUMINESZENZVORRICHTUNG**
ORGANIC ELECTROLUMINESCENCE DEVICE
DISPOSITIF ÉLECTROLUMINESCENT ORGANIQUE

(30) Priorität: 03.06.2011 EP 11004544
(43) Veröffentlichungstag der Anmeldung: 09.04.2014
(73) Patentinhaber: Merck Patent GmbH, 64293 Darmstadt (DE)
(72) Erfinder: PARHAM, Amir Hossain, 65929 Frankfurt am Main (DE); BUESING, Arne, 65929 Frankfurt am Main (DE); PLUMM, Christof, 64291 Darmstadt (DE); MUJICA-FERNAUD, Teresa, 64283 Darmstadt (DE); STOESSEL, Philipp, 60487 Frankfurt am Main (DE); EBERLE, Thomas, 76829 Landau (DE)
(86) Internationale Anmeldenummer: PCT/EP2012/001950
(87) Internationale Veröffentlichungsnummer: WO 2012/163465

(56) Entgegenhaltungen:
- EP-A2- 2 311 826
- WO-A1-2007/011163
- WO-A1-2011/019156
- HARUHIKO TOMODA ET AL: "Substituent Effects on Fluorescent Properties of Imidazo [1,2-a] pyridine-Based Compounds", BULLETIN OF THE CHEMICAL SOCIETY OF JAPAN, CHEMICAL SOCIETY OF JAPAN, TOKYO, JP, Bd. 72, Nr. 6, 1. Januar 1999 (1999-01-01) , Seiten 1327-1334, XP008141813, ISSN: 0009-2673

## Beschreibung

Die vorliegende Erfindung betrifft organische Elektrolumineszenzvorrichtungen, welche heteroaromatische Verbindungen enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei häufig metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDS, die Triplettemission (Phosphoreszenz) zeigen, immer noch Verbesserungsbedarf, beispielsweise im Hinblick auf Effizienz, Betriebsspannung und Lebensdauer.

Die Eigenschaften von phosphoreszierenden OLEDs werden nicht nur von den eingesetzten Triplettemittern bestimmt. Hier sind insbesondere auch die anderen verwendeten Materialien, wie Matrixmaterialien, Lochblockiermaterialien, Elektronentransportmaterialien, Lochtransportmaterialien und Elektronen- bzw. Exzitonenblockiermaterialien von besonderer Bedeutung. Verbesserungen dieser Materialien können somit auch zu deutlichen Verbesserungen der OLED-Eigenschaften führen. Auch für fluoreszierende OLEDs gibt es bei diesen Materialien noch Verbesserungsbedarf.

Gemäß dem Stand der Technik werden unter anderem Ketone (z. B. gemäß WO 2004/093207 oder WO 2010/006680), Phosphinoxide (z. B. gemäß WO 2005/003253) oder Triazinderivate (z. B. gemäß WO 2010/015306) als Matrixmaterialien für phosphoreszierende Emitter verwendet. Allerdings besteht bei Verwendung dieser Matrixmaterialien ebenso wie bei anderen Matrixmaterialien noch Verbesserungsbedarf, insbesondere in Bezug auf die Effizienz, die Lebensdauer und die Betriebsspannung der Vorrichtung.

Aufgabe der vorliegenden Erfindung ist die Bereitstellung von Verbindungen, welche sich für den Einsatz in einer fluoreszierenden oder phosphoreszierenden OLED, insbesondere einer phosphoreszierenden OLED, eignen, beispielsweise als Matrixmaterial oder als Lochtransport-/ Elektronenblockiermaterial bzw. Exzitonenblockiermaterial oder als Elektronentransport- bzw. Lochblockiermaterial. Insbesondere ist es die Aufgabe der vorliegenden Erfindung, neue Matrixmaterialien für phosphoreszierende Verbindungen, sowie neue Lochtransportmaterialien und Elektronentransportmaterialien bereitzustellen.

Überraschend wurde gefunden, dass bestimmte, unten näher beschriebene Verbindungen diese Aufgabe lösen und zu Verbesserungen der organischen Elektrolumineszenzvorrichtung führen, insbesondere hinsichtlich der Lebensdauer, der Effizienz und der Betriebsspannung. Dies gilt insbesondere auch für phosphoreszierende Elektrolumineszenzvorrichtungen, vor allem bei Einsatz der erfindungsgemäßen Verbindungen als Matrixmaterial, aber auch für den Einsatz der Verbindungen als Lochtransportmaterial, Lochinjektionsmaterial, Elektronentransportmaterial oder Lochblockiermaterial, je nach genauer Substitution der Verbindung. Organische Elektrolumineszenzvorrichtungen, welche derartige Verbindungen enthalten, sind daher der Gegenstand der vorliegenden Erfindung.

Aus der WO 2010/086089 sind Metallkomplexe bekannt, die Imidazoisochinolin-Derivate als Liganden enthalten. Die Verwendung derartiger Imidazoisochinolin-Derivate, die nicht an ein Metall koordiniert sind, in organischen Elektrolumineszenzvorrichtungen ist nicht beschrieben.

Aus der WO 2010/062065 sind weiterhin Benzimidazophenanthridin-Derivate bekannt. Bei diesen Verbindungen gibt es jedoch noch Verbesserungsbedarf, insbesondere in Bezug auf die Triplettenergie, um diese Verbindungen als Matrixmaterial für Triplettemitter, insbesondere auch für grüne Triplettemitter, einsetzen zu können.

WO 2007/011163 A1 offenbart Naphthoimidazopyridine und deren Verwendung in elektrolumineszierenden Vorrichtungen.

EP 2 311 826 A2 offenbart Imidazophenanthridine und deren Verwendung

in elektronischen Vorrichtungen.

Es hat sich überraschend gezeigt, dass gerade der Einsatz der nachfolgend beschriebenen Verbindungen in organischen Elektrolumineszenzvorrichtungen zu guten elektronischen Eigenschaften führt.

Gegenstand der vorliegenden Erfindung ist daher eine organische Elektrolumineszenzvorrichtung enthaltend eine Verbindung gemäß einer der folgenden Formel (1) oder Formel (2), 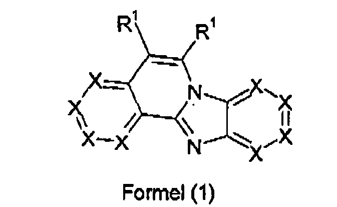 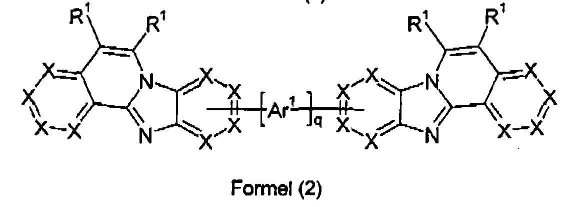 wobei für die verwendeten Symbole und Indizes gilt:
X ist bei jedem Auftreten gleich oder verschieden CR oder N, mit der Maßgabe, dass jeweils maximal zwei Gruppen X, die direkt aneinander gebunden sind, für N stehen;
R, R¹ sind wie in Anspruch 1 angegeben definiert;
Ar¹ ist gleich oder verschieden bei jedem Auftreten eine bivalente Aryl-oder Heteroarylgruppe mit 5 bis 18 C-Atomen, welche durch einen oder mehrere Reste R² substituiert sein kann;
R² ist bei jedem Auftreten gleich oder verschieden ausgewählt aus der Gruppe bestehend aus H, D, F, Cl, Br, l, CN, NO₂, N(Ar)₂, N(R³)₂, C(=O)Ar, C(=O)R³, P(=O)(Ar)₂, einer geradkettigen Alkyl-, Alkoxy-oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten R³ substituiert sein kann, wobei eine oder mehrere nicht-benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringätomen, das jeweils mit einem oder mehreren Resten R³ substituiert sein kann, einer Aryloxy- oder Heteroaryloxygruppe mit 5 bis 60 aromatischen Ringatomen, die mit einem oder mehreren Resten R³ substituiert sein kann, oder eine Aralkyl-oder Heteroaralkylgruppe mit 5 bis 60 aromatischen Ringatomen, wobei optional zwei oder mehr benachbarte Substituenten R² ein monocyclisches oder polycyclisches, aliphatisches, aromatisches oder heteroaromatisches Ringsystem bilden können, das mit einem oder mehreren Resten R³ substituiert sein kann;
Ar ist bei jedem Auftreten gleich oder verschieden ein aromatisches oder heteroaromatisches Ringsystem mit 5-30 aromatischen Ringatomen, das mit einem oder mehreren nicht-aromatischen Resten R³ substituiert sein kann; dabei können zwei Reste Ar, welche an dasselbe N-Atom oder P-Atom binden, auch durch eine Einfachbindung oder eine Brücke, ausgewählt aus N(R³), C(R³)₂, O oder S, miteinander verbrückt sein;
R³ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten R³ miteinander ein mono- oder polycyclisches, aliphatisches, aromatisches oder heteroaromatisches Ringsystem bilden können;
q ist bei jedem Auftreten gleich oder verschieden 0, 1, 2 oder 3.

Der Begriff "mit der Maßgabe, dass jeweils maximal zwei Gruppen X, die direkt aneinander gebunden sind, für N stehen" in der Definition von X bedeutet, dass nicht drei oder mehr N-Atome direkt in einem der Ringe der Verbindung gemäß Formel (1) aneinander gebunden sein können.

Die erfindungsgemäße organische Elektrolumineszenzvorrichtung enthält Anode, Kathode und mindestens eine emittierende Schicht, welche zwischen der Anode und der Kathode angeordnet ist, und kann noch weitere Schichten enthalten. Die organische Elektrolumineszenzvorrichtung muss nicht notwendigerweise nur Schichten enthalten, welche aus organischen oder metallorganischen Materialien aufgebaut sind. So ist es auch möglich, dass Anode, Kathode und/oder eine oder mehrere Schichten anorganische Materialien enthalten oder ganz aus anorganischen Materialien aufgebaut sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryt- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind. Weiterhin werden miteinander durch Einfachbindung verknüpfte Aromaten, wie zum Beispiel Biphenyl, als aromatisches Ringsystem im Sinne dieser Anmeldung bezeichnet.

Im Rahmen der vorliegenden Erfindung werden unter einem aliphatischen Kohlenwasserstoffrest bzw. einer Alkylgruppe bzw. einer Alkenyl- oder Alkinylgruppe, die typischerweise 1 bis 40 oder auch 1 bis 20 C-Atome enthalten kann, und in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenytthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkenyl-, Alkinyl-, Alkoxy- oder Thioalkylgruppen gemäß der vorliegenden Erfindung geradkettig, verzweigt oder cyclisch sein, wobei eine oder mehrere nicht-benachbarte CH₂-Gruppen durch die oben genannten Gruppen ersetzt sein können; weiterhin können auch ein oder mehrere H-Atome durch D, F, CI, Br, I, CN oder NO₂, bevorzugt F, CI oder CN, weiter bevorzugt F oder CN, besonders bevorzugt CN ersetzt sein.

Unter einem aromatischen oder heteroaromatischen Ringsystem mit 5 - 80 aromatischen Ringatomen, welches noch jeweils mit den oben genannten Resten R² oder einem Kohlenwasserstoffrest substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-lndeno-carbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombination dieser Systeme.

Unter benachbarten Resten im Sinne der vorliegenden Erfindung werden Reste verstanden, die an Atome gebunden sind, welche direkt aneinander gebunden sind. Dabei sind die Reste wie oben definiert, und zwei Reste binden jeweils unter formaler Abspaltung eines Wasserstoffatoms aneinander. Wenn es sich bei den Resten um Alkylgruppen handelt, ist so beispielsweise die Bildung einer ankondensierten Cycloalkylgruppe möglich. Wenn es sich bei den Resten um Vinylgruppen bzw. um eine Vinylgruppe und ein Wasserstoffatom handelt, ist so beispielsweise die Bildung einer kondensierten Arylgruppe möglich.

Gemäß Anspruch 1 bilden benachbarte Reste R keinen Ring miteinander. Gemäß Anspruch 1 bilden benachbarte Reste R¹ keinen Ring miteinander.

In einer bevorzugten Ausführungsform der Formel (1) bzw. Formel (2) steht in jedem Cyclus maximal eine Gruppe X für N, und die anderen Gruppen X stehen gleich oder verschieden bei jedem Auftreten für CR. In einer besonders bevorzugten Ausführungsform der Formel (1) bzw. Formel (2) steht in jeder Benzimidazoisochinolin-Einheit bzw. in jeder hiervon abgeleitetet Einheit insgesamt maximal eine Gruppe X für N, und die anderen Gruppen X stehen gleich oder verschieden bei jedem Auftreten für CR. In einer ganz besonders bevorzugten Ausführungsform der Formel (1) bzw. Formel (2) stehen alle Gruppen X gleich oder verschieden bei jedem Auftreten für CR.

Besonders bevorzugte Ausführungsformen der Formel (1) sind daher die Strukturen der folgenden Formeln (3) bis (11), 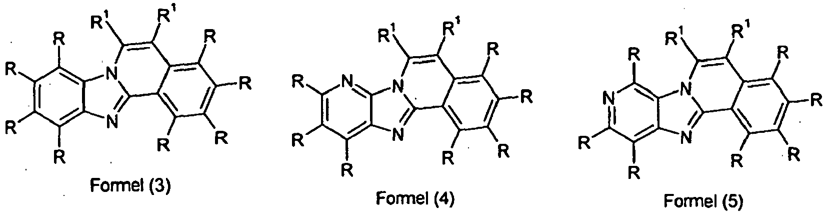 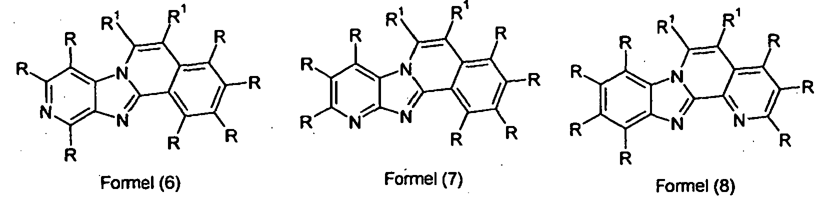 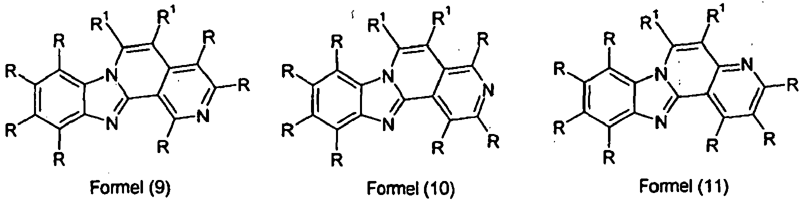 wobei die verwendeten Symbole die oben genannten Bedeutungen aufweisen.

Besonders bevorzugt sind unter diesen Strukturen die Strukturen der Formeln (3), (4) und (7).

Bevorzugte Ausführungsformen der Formel (2) sind Strukturen gemäß der folgenden Formel (12), 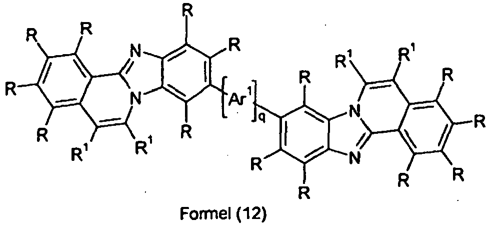 wobei die verwendeten Symbole und Indizes die oben genannten Bedeutungen aufweisen.

In einer weiteren bevorzugten Ausführungsform der Verbindungen gemäß Formel (1) bzw. Formel (2) ist mindestens eine Gruppe R und/oder R¹ ungleich H oder D. Besonders bevorzugt sind genau insgesamt eine oder zwei Gruppen R bzw. R¹ ungleich H oder D.

Dabei sind besonders bevorzugte Ausführungsformen der Verbindungen gemäß Formel (3) die Verbindungen der folgenden Formeln (3a) bis (3i), 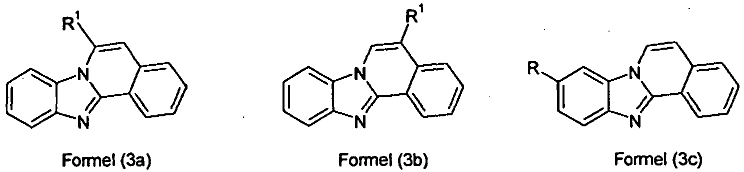 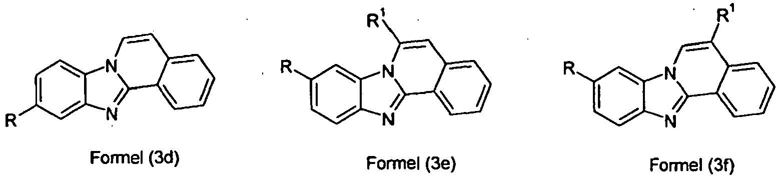 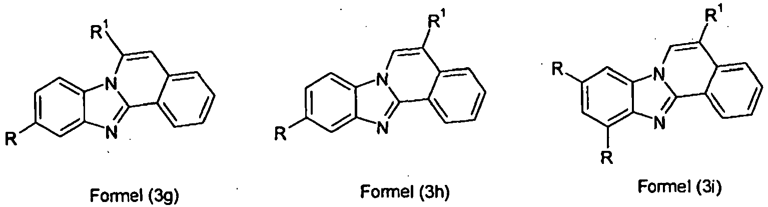 wobei die verwendeten Symbole die oben genannten Bedeutungen aufweisen und R und R¹ ungleich H oder D sind. Dabei sind bevorzugte Strukturen die Verbindungen gemäß den Formeln (3c), (3f) und (3i).

Als Substituenten R bzw. R¹ sind verschiedene Gruppen möglich, je nach der Verwendung der Verbindungen. In einer bevorzugten Ausführungsform der Erfindung ist R bzw. R¹ bei jedem Auftreten gleich oder verschieden ausgewählt aus der Gruppe bestehend aus H, D, F, CN, N(Ar)₂, C(=O)Ar, P(=O)(Ar)₂, einer geradkettigen Alkylgruppe mit 1 bis 10 C-Atomen oder einer verzweigten oder cyclischen Alkylgruppe mit 3 bis 10 C-Atomen oder einer Alkenylgruppe mit 2 bis 10 C-Atomen, die jeweils mit einem oder mehreren Resten R² substituiert sein kann, wobei eine oder mehrere nicht-benachbarte CH₂-Gruppen durch O oder S ersetzt sein können und wobei ein oder mehrere H-Atome durch D oder F ersetzt sein können, einem aromatischen oder heteroaromatischen Ringsystem mit 6 bis 30 aromatischen Ringatomen, das jeweils mit einem oder mehreren Resten R² substituiert sein kann.

In einer besonders bevorzugten Ausführungsform der Erfindung ist R bzw. R² bei jedem Auftreten gleich oder verschieden ausgewählt aus der Gruppe bestehend aus H, D, N(Ar)₂ oder einem aromatischen oder heteroaromatischen Ringsystem mit 6 bis 18 aromatischen Ringatomen, das jeweils mit einem oder mehreren Resten R² substituiert sein kann.

Dabei haben für Verbindungen, die durch Vakuumverdampfung verarbeitet werden, die Alkylgruppen in den Resten R bzw. R¹ bzw. R² bevorzugt nicht mehr als vier C-Atome, besonders bevorzugt nicht mehr als ein C-Atom. Für Verbindungen, die aus Lösung verarbeitet werden, eignen sich insbesondere auch Verbindungen, die mit Alkylgruppen mit bis zu 10 C-Atomen substituiert sind oder die mit Oligoarylengruppen, beispielsweise ortho-, meta-, para- oder verzweigten Terphenylgruppen bzw. Quaterphenylgruppen oder ortho-, meta- oder para-Biphenylgruppen, substituiert sind.

Je nach Schicht, in der die Verbindung gemäß Formel (1) bzw. Formel (2) bzw. die bevorzugten Ausführungsformen eingesetzt werden, sind die Substituenten R bzw. R¹ unterschiedlich gewählt.

Wenn die erfindungsgemäße Verbindung als Matrixmaterial für einen phosphoreszierenden Emitter oder als Elektronentransportmaterial oder als Lochblockiermaterial eingesetzt wird, ist bevorzugt mindestens ein Substituent R und/oder R¹ eine elektronenarme Gruppe, insbesondere ausgewählt aus Strukturen gemäß den folgenden Formeln (13) bis (17), 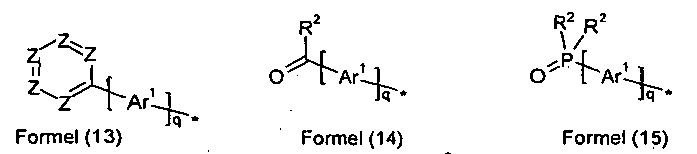 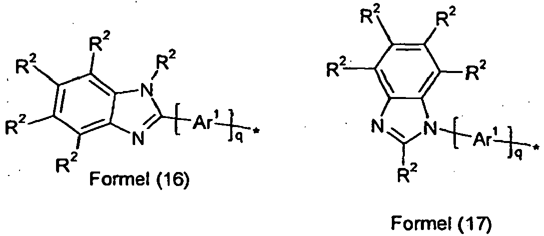 wobei R², Ar¹ und q die oben genannten Bedeutungen haben, * die Position der Bindung an den Grundkörper der Formel (1) bzw. Formel (2) andeutet und weiterhin gilt:
Z ist bei jedem Auftreten gleich oder verschieden CR² oder N, mit der Maßgabe, dass eine Gruppe Z, zwei Gruppen Z oder drei Gruppen Z für N stehen.

In einer besonders bevorzugten Ausführungsform der Erfindung steht mindestens ein Substituent R oder R¹ für eine Gruppe der oben genannten Formel (13), wobei jeweils zwei oder drei Symbole Z für N stehen und die anderen Symbole Z für CR² stehen. Besonders bevorzugte Gruppen R bzw. R¹ sind daher die Gruppen der folgenden Formeln (18) bis (24), 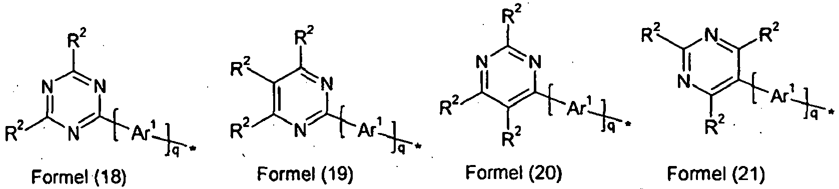 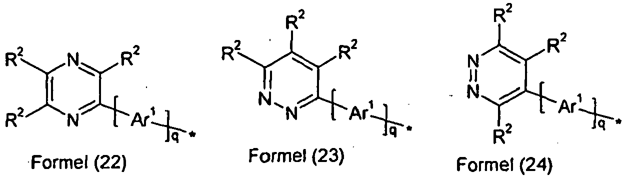 wobei die verwendeten Symbole und Indizes die oben genannten Bedeutungen aufweisen.

Wenn R bzw. R¹ für eine Gruppe der Formel (18) steht, dann steht R² in dieser Gruppe bevorzugt für ein aromatisches oder heteroaromatisches Ringsystem mit 5 bis 24 aromatischen Ringatomen, welches durch einen oder mehrere Reste R³ substituiert sein kann, insbesondere für Phenyl, ortho-, meta- oder para-Biphenyl, ortho-, meta-, para- oder verzweigtes Terphenyl oder ortho-, meta-, para- oder verzweigtes Quaterphenyl.

Wenn R für eine Gruppe der Formel (19) bis (24) steht, dann steht R² in diesen Gruppen bevorzugt gleich oder verschieden bei jedem Auftreten für H, D oder ein aromatisches oder heteroaromatisches Ringsystem mit 5 bis 24 aromatischen Ringatomen, welches durch einen oder mehrere Reste R³ substituiert sein kann, insbesondere für Phenyl, ortho-, meta- oder para-Biphenyl, ortho-, meta-, para- oder verzweigtes Terphenyl oder ortho-, meta-, para- oder verzweigtes Quaterphenyl.

Wenn die erfindungsgemäße Verbindung als Matrixmaterial für einen phosphoreszierenden Emitter oder als Lochtransportmaterial oder als Elektronenblockiermaterial eingesetzt wird, ist mindestens ein Substituent R oder R¹ bevorzugt ausgewählt aus der Gruppe bestehend aus -NAr₂, Triarylaminderivaten, Carbazolderivaten, Indenocarbazolderivaten, Indolocarbazolderivaten, Azacarbazolderivaten, Indolderivaten, Furanderivaten, Benzofuranderivaten, Dibenzofuranderivaten, Thiophenderivaten, Benzothiophenderivaten oder Dibenzothiophenderivaten, welche jeweils durch einen oder mehrere Reste R² substituiert sein können. Diese Gruppen sind bevorzugt ausgewählt aus den Gruppen der folgenden Formeln (25) bis (42), 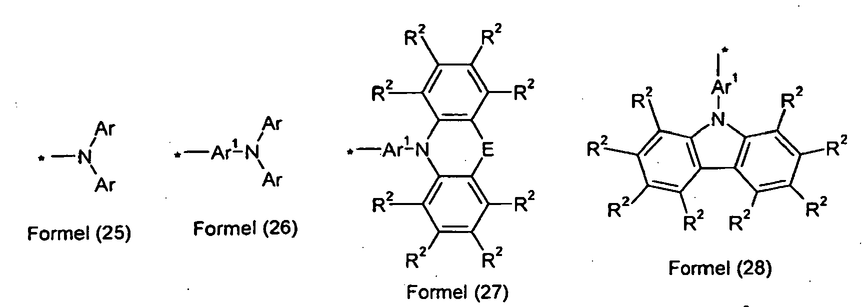 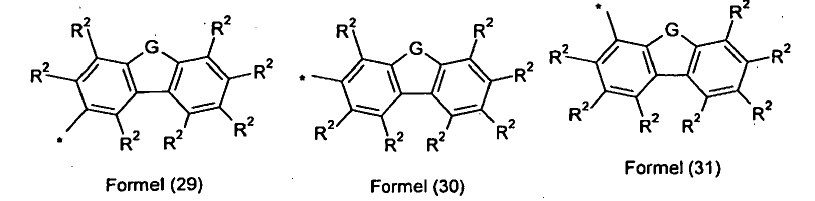 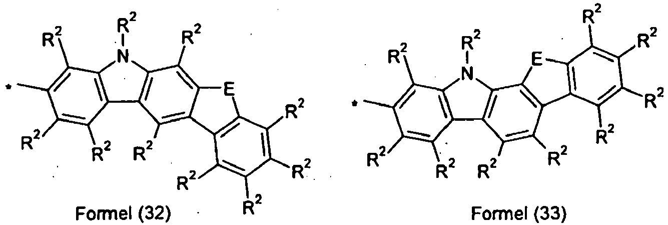 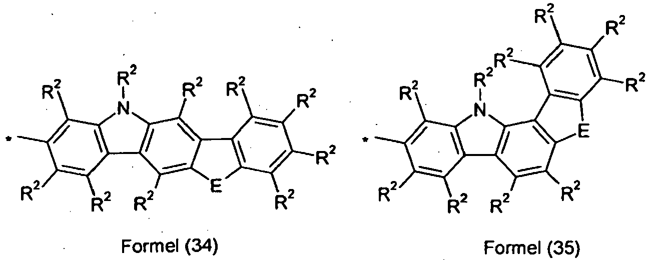 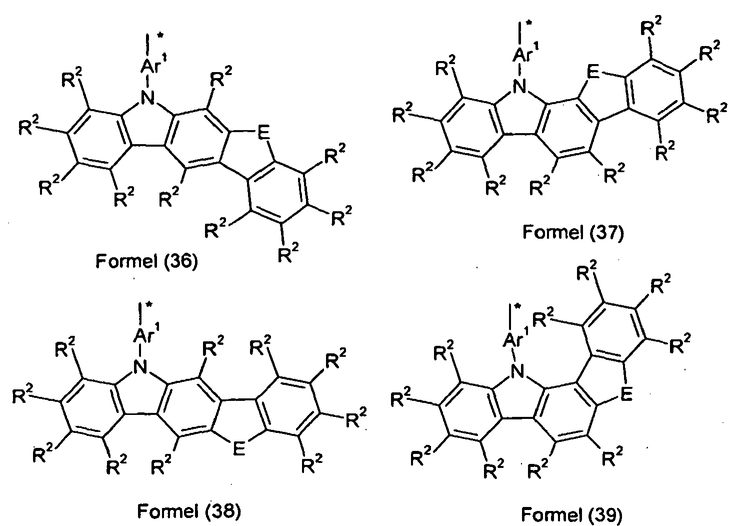 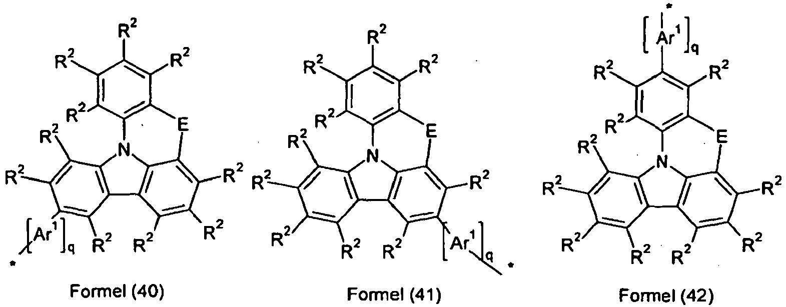 wobei die verwendeten Symbole die oben genannten Bedeutungen aufweisen und weiterhin gilt:
E ist ausgewählt aus der Gruppe bestehend aus C(R²)₂, NR², O oder S;
G ist ausgewählt aus der Gruppe bestehend aus NR², O oder S.

Weitere bevorzugte Reste R bzw. R¹ sind ausgewählt aus der Gruppe der aromatischen Ringsysteme enthaltend Benzol, Naphthalin, Fluoren, Spirobifluoren, Anthracen, Benzanthracen, Phenanthren, Triphenylen oder eine Kombination aus zwei, drei oder vier dieser Gruppen, die gleich oder verschieden sein können; dabei können diese Gruppen auch durch einen oder mehrere Reste R² substituiert sein. Besonders bevorzugt sind ortho-, meta- oder para-Biphenyl, ortho-, meta-, para- oder verzweigtes Terphenyl oder verzweigte Quaterphenylstrukturen.

Die oben genannten Ausführungsformen der Erfindung sind beliebig miteinander kombinierbar. Insbesondere sind die oben aufgeführten allgemeinen Formeln (1) oder (2) bzw. (3) bis (12) bzw. (3a) bis (3i) beliebig mit den oben genannten bevorzugten Ausführungsformen für X, R und R¹ kombinierbar. In einer bevorzugten Ausführungsform der Erfindung treten die oben genannten Bevorzugungen gleichzeitig auf.

Beispiele für Verbindungen, wie sie bevorzugt in den erfindungsgemäßen organischen Elektrolumineszenzvorrichtungen eingesetzt werden können, sind die folgenden Verbindungen.

| | |
|---|---|
| 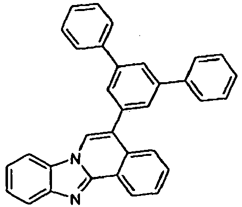 | 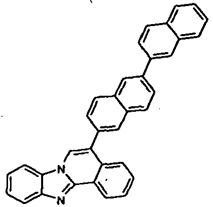 |
| (1) | (2) |
| 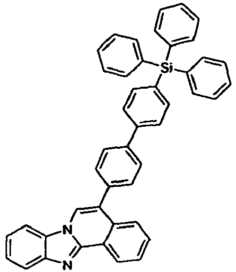 | 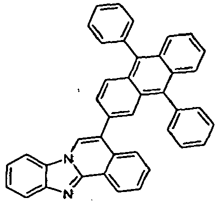 |
| (3) | (4) |
| 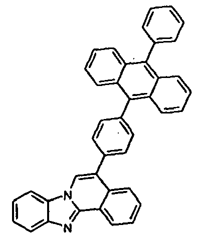 | 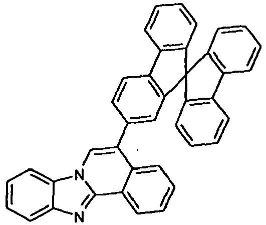 |
| (5) | (6) |
| 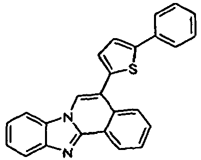 | 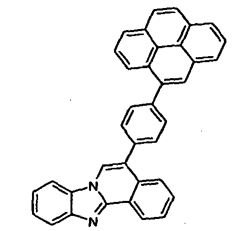 |
| (7) | (8) |
| 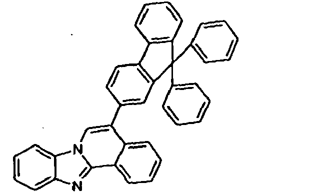 | 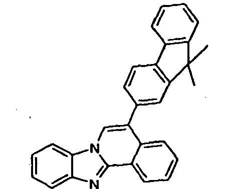 |
| (9) | (10) |
| 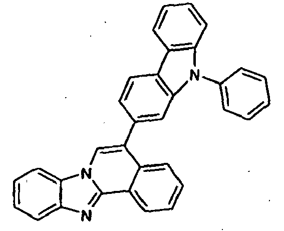 | 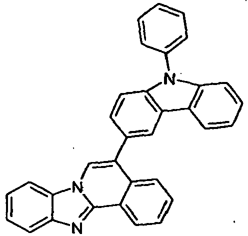 |
| (11) | (12) |
| 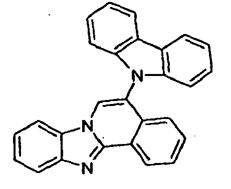 | 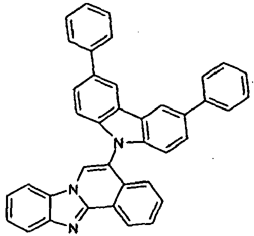 |
| (13) | (14) |
| 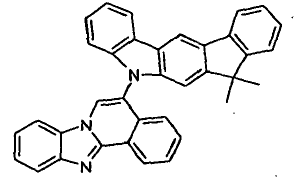 | 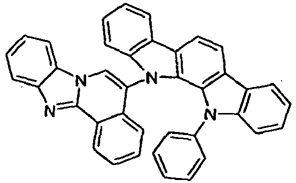 |
| (15) | (16) |
| 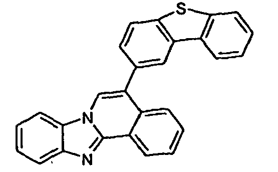 | 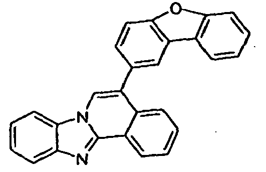 |
| (17) | (18) |
| 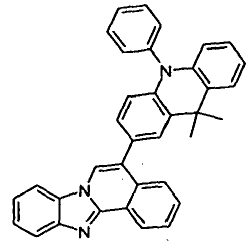 | 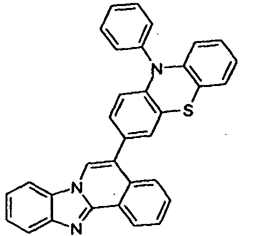 |
| (19) | (20) |
| 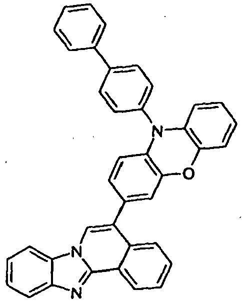 | 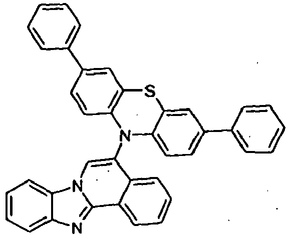 |
| (21) | (22) |
| 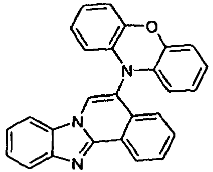 | 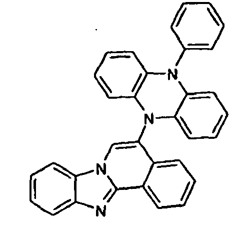 |
| (23) | (24) |
| 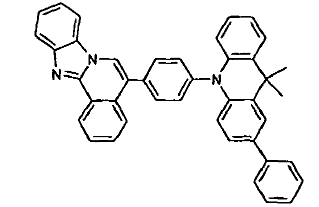 | 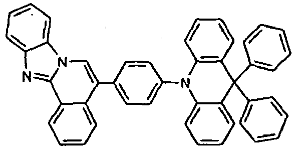 |
| (25) | (26) |
| 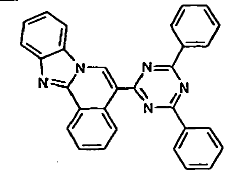 | 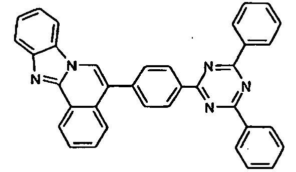 |
| (27) | (28) |
| 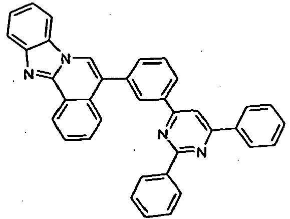 | 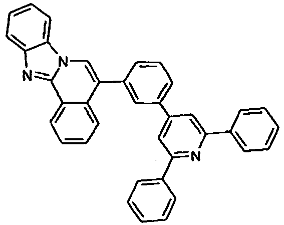 |
| (29) | (30) |
| 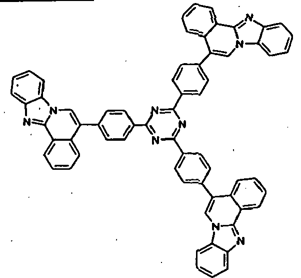 | 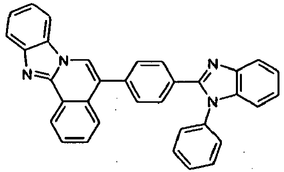 |
| (31) | (32) |
| 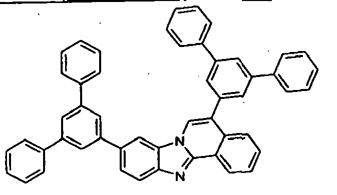 | 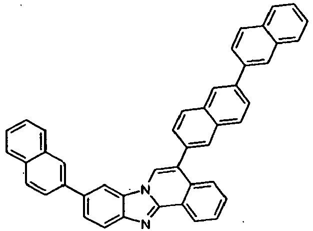 |
| (33) | (34) |
| 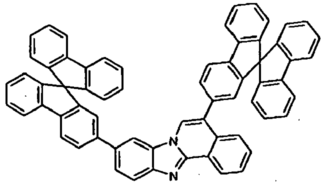 | 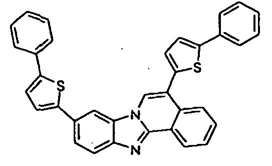 |
| (35) | (36) |
| 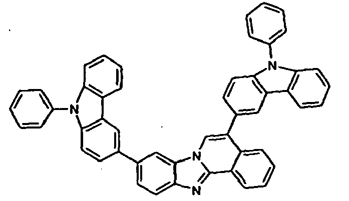 | 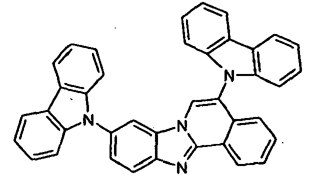 |
| (37) | (38) |
| 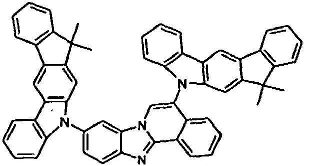 | 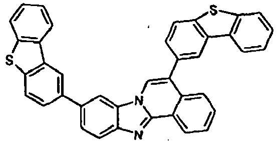 |
| (39) | (40) |
| 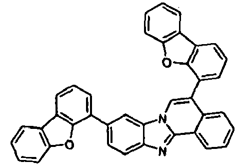 | 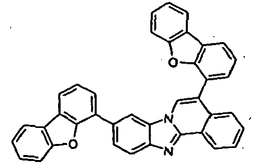 |
| (41) | (42) |
| 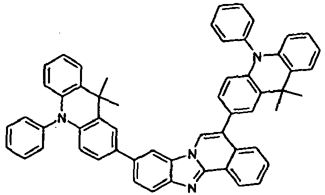 | 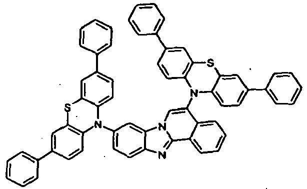 |
| (43) | (44) |
| 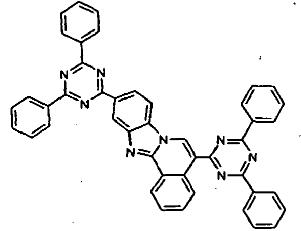 | 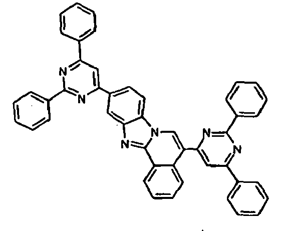 |
| (45) | (46) |
| 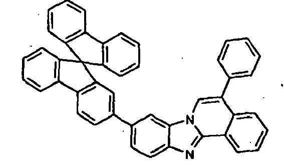 | 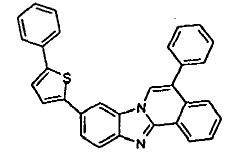 |
| (47) | (48) |
| 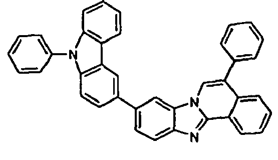 | 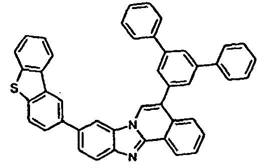 |
| (49) | (50) |
| 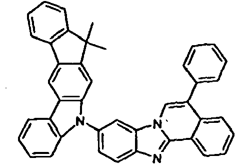 | 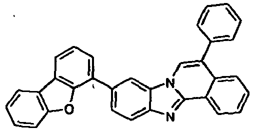 |
| (51) | (52) |
| 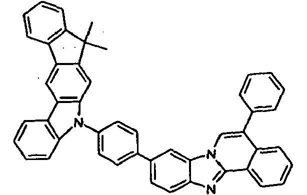 | 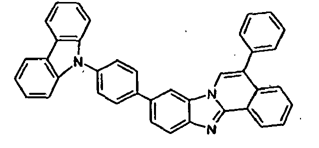 |
| (53) | (54) |
| 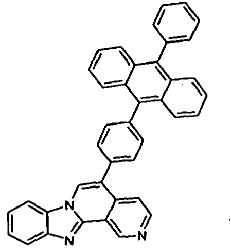 | 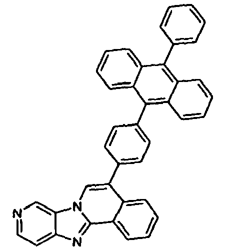 |
| (55) | (56) |
| 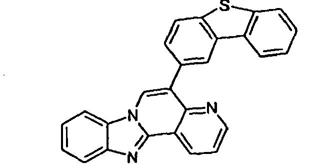 | 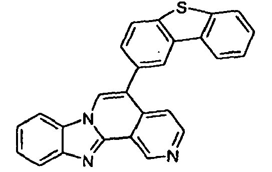 |
| (57) | (58) |
| 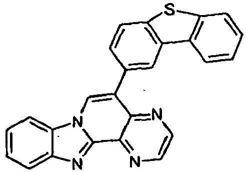 | 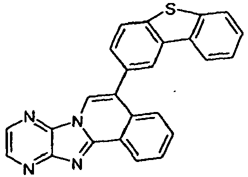 |
| (59) | (60) |
| 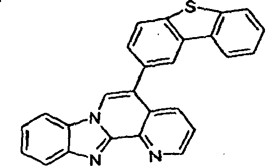 | 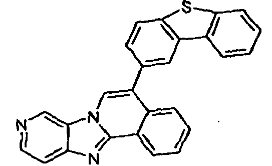 |
| (61) | (62) |
| 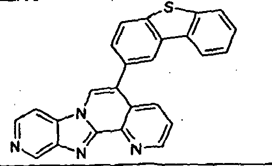 | 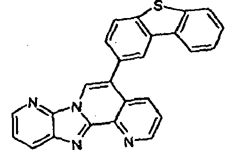 |
| (63) | (64) |
| 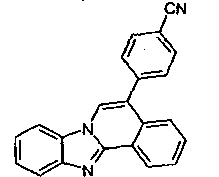 | 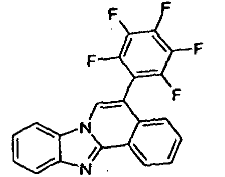 |
| (65) | (66) |
| 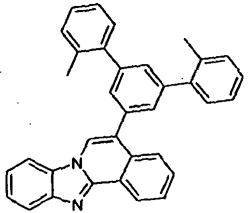 | 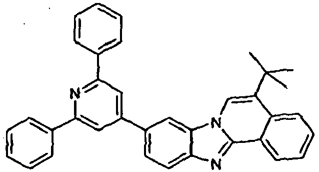 |
| (67) | (68) |
| 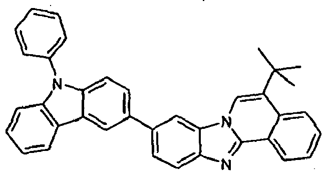 | 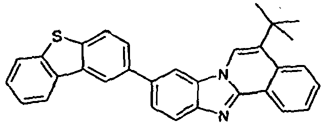 |
| (69) | (70) |
| 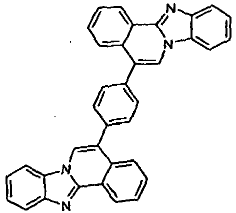 | 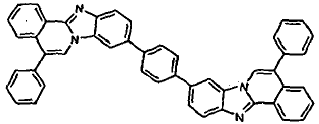 |
| (71) | (72) |
| 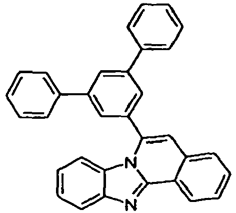 | 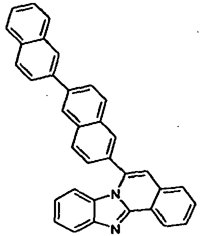 |
| (73) | (74) |
| 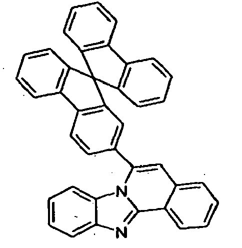 | 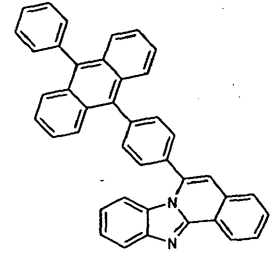 |
| (75) | (76) |
| 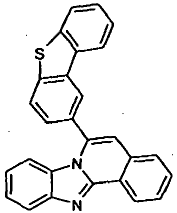 | 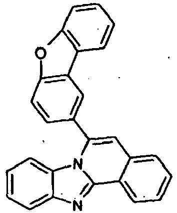 |
| (77) | (78) |
| 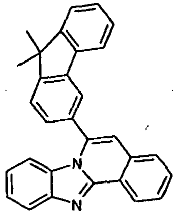 | 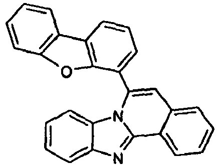 |
| (79) | (80) |
| 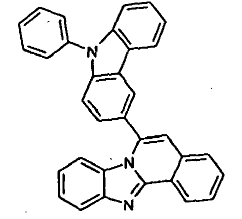 | 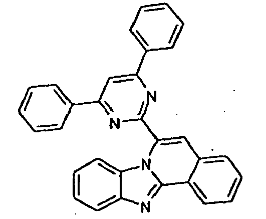 |
| (81) | (82) |
| 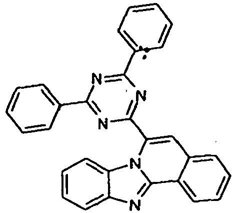 | 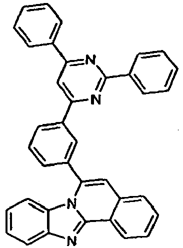 |
| (83) | (84) |
| 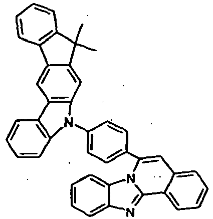 | 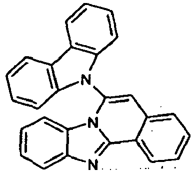 |
| (85) | (86) |
| 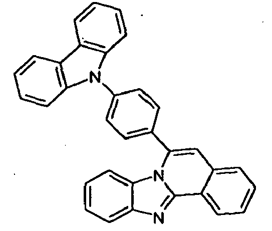 | 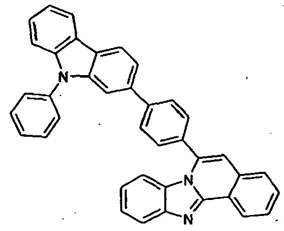 |
| (87) | (88) |
| 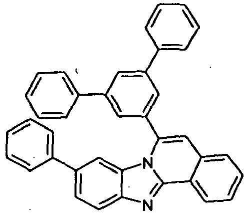 | 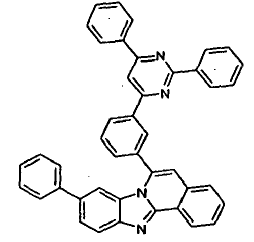 |
| (89) | (90) |
| 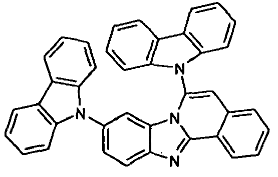 | 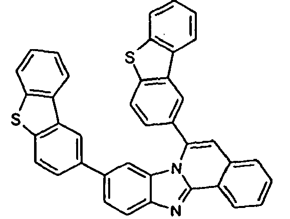 |
| (91) | (92) |
| 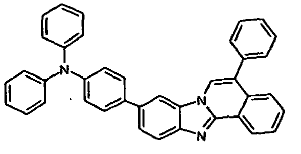 | 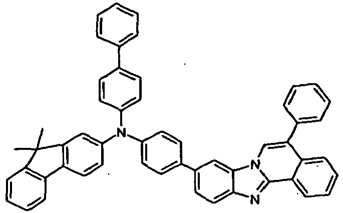 |
| (93) | (94) |
| 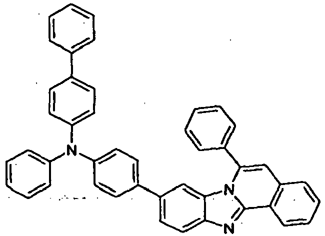 | 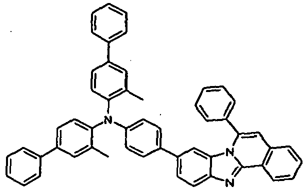 |
| (95) | (96) |
| 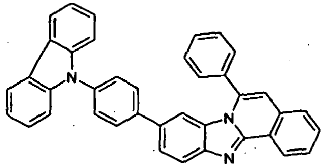 | 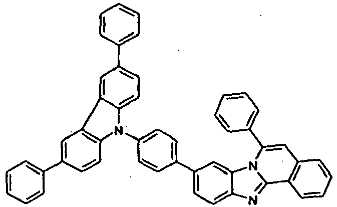 |
| (96) | (97) |
| 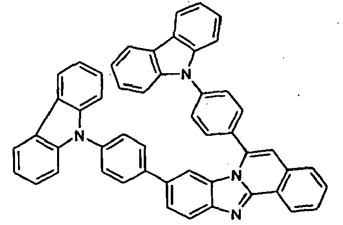 | 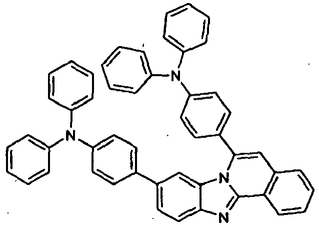 |
| (98) | (99) |
| 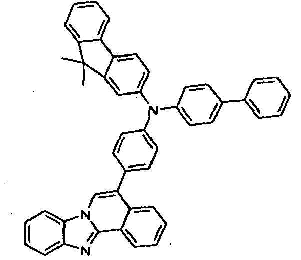 | 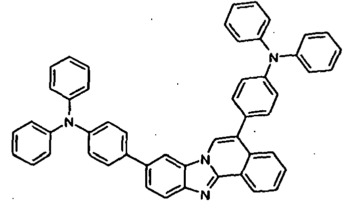 |
| (100) | (101) |
| 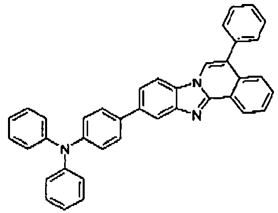 | 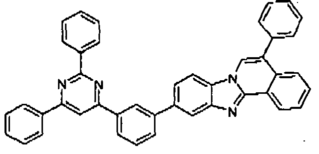 |
| (101a) | (102) |
| 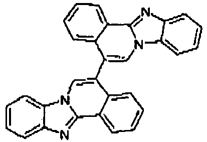 | 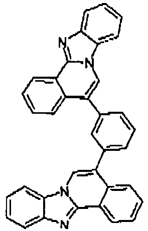 |
| (115) | (116) |
| 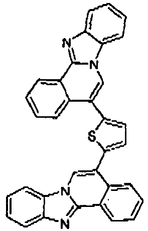 | 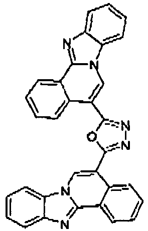 |
| (117) | (118) |
| 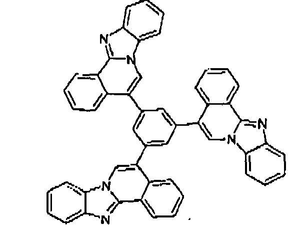 | 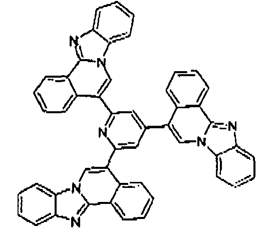 |
| (118) | (120) |
| 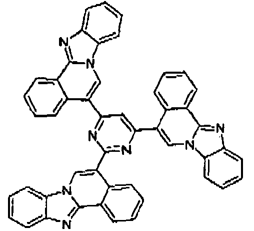 | 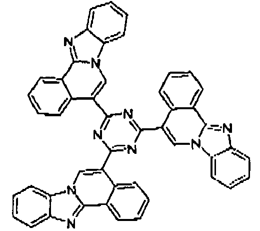 |
| (121) | (122) |
| 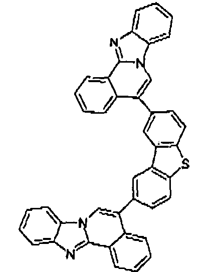 | 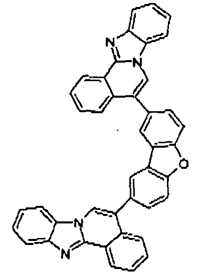 |
| (123) | (124) |
| 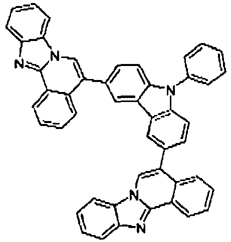 | 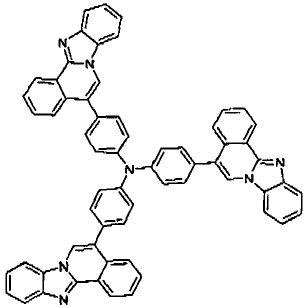 |
| (125) | (126) |

Die Synthese der Verbindungen gemäß Formel (1) erfolgt ausgehend von literaturbekannten Verbindungen wie im Folgenden dargestellt. Die Synthese der Grundbausteine der Verbindungen gemäß Formel (1) bzw. Formel (2) ist aus der WO 2011/157339 bekannt. Dabei eignen sich vor allem die halogenierten, insbesondere die bromierten Grundbausteine als Ausgangsstufe zur Synthese der Verbindungen gemäß Formel (1) bzw. Formel (2). Diese können durch Standardreaktionen der organischen Chemie, wie zum Beispiel Suzuki-Kupplung, Hartwig-Buchwald-Kupplung, etc. zu den Verbindungen gemäß Formel (1) bzw. Formel (2) umgesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Zwischenschichten (Interlayer) eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen (für den prinzipiellen Aufbau siehe z. B. WO 2005/011013). Es kann sich dabei um fluoreszierende oder um phosphoreszierende Emissionsschichten handeln oder um Hybrid-Systeme, bei denen fluoreszierende und phosphoreszierende Emissionsschichten miteinander kombiniert werden.

Die Verbindung gemäß Formel (1) bzw. Formel (2) kann dabei in unterschiedlichen Schichten eingesetzt werden, je nach genauer Struktur.

In einer bevorzugten Ausführungsform der Erfindung wird die Verbindung gemäß Formel (1) bzw. Formel (2) bzw. gemäß einer der bevorzugten Ausführungsformen als Matrixmaterial für eine fluoreszierende oder phosphoreszierende Verbindung, insbesondere für eine phosphoreszierende Verbindung, in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel (1) bzw. Formel (2) bzw. gemäß einer der bevorzugten Ausführungsformen als Matrixmaterial enthält.

Wenn die Verbindung gemäß Formel (1) bzw. Formel (2) bzw. gemäß einer der bevorzugten Ausführungsformen als Matrixmaterial für eine emittierende Verbindung in einer emittierenden Schicht eingesetzt wird, wird sie bevorzugt in Kombination mit einem oder mehreren phosphoreszierenden Materialien (Triplettemitter) eingesetzt. Unter Phosphoreszenz im Sinne dieser Erfindung wird die Lumineszenz aus einem angeregten Zustand mit höherer Spinmultiptizität verstanden, also einem Spinzustand > 1, insbesondere aus einem angeregten Triplettzustand. Im Sinne dieser Anmeldung sollen alle lumineszierenden Übergangsmetallkomplexe und lumineszierenden Lanthanidkomplexe, insbesondere alle Iridium-, Platin-und Kupferkomplexe als phosphoreszierende Verbindungen angesehen werden.

Die Mischung aus der Verbindung gemäß Formel (1) bzw. Formel (2) bzw. gemäß einer der bevorzugten Ausführungsformen und der emittierenden Verbindung enthält zwischen 99 und 1 Vol.-%, vorzugsweise zwischen 98 und 10 Vol.-%, besonders bevorzugt zwischen 97 und 60 Vol.-%, insbesondere zwischen 95 und 80 Vol.-% der Verbindung gemäß Formel (1) bzw. Formel (2) bzw. gemäß einer der bevorzugten Ausführungsformen bezogen auf die Gesamtmischung aus Emitter und Matrixmaterial. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 20 Vol.-% des Emitters bezogen auf die Gesamtmischung aus Emitter und Matrixmaterial.

Eine weitere bevorzugte Ausführungsform der vorliegenden Erfindung ist der Einsatz der Verbindung gemäß Formel (1) bzw. Formel (2) bzw. gemäß einer der bevorzugten Ausführungsformen als Matrixmaterial für einen phosphoreszierenden Emitter in Kombination mit einem weiteren Matrixmaterial. Besonders geeignete Matrixmaterialien, welche in Kombination mit den Verbindungen gemäß Formel (1) bzw. Formel (2) bzw. gemäß einer der bevorzugten Ausführungsformen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109 und WO 2011/000455, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, oder überbrückte Carbazol-Derivate, z. B. gemäß US 2009/0136779, WO 2010/050778, WO 2011/042107 oder WO 2011/088877. Ebenso kann ein weiterer phosphoreszierender Emitter, welcher kürzerwellig als der eigentliche Emitter emittiert, als Co-Host in der Mischung vorhanden sein.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenz emitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten. Im Sinne der vorliegenden Erfindung werden alle lumineszierenden Verbindungen, die die oben genannten Metalle enthalten, als phosphoreszierende Verbindungen angesehen.

Beispiele der oben beschriebenen Emitter können den Anmeldungen WO 00/70655. WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339 und WO 2012/007086 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 2005/053051 beschrieben. Weiterhin ist es möglich, einen Metallkomplex, der gleich oder ähnlich dem Metallkomplex in der emittierenden Schicht ist, direkt angrenzend an die emittierende Schicht als Lochtransport- bzw. Lochinjektionsmaterial zu verwenden, wie z. B. in WO 2009/030981 beschrieben.

In einer weiteren bevorzugten Ausführungsform der Erfindung wird die Verbindung gemäß Formel (1) bzw. Formel (2) bzw. gemäß den bevorzugten Ausführungsformen als Elektronentransportmaterial in einer Elektronentransport- oder Elektroneninjektionsschicht eingesetzt. Dabei ist bevorzugt mindestens ein Substituent R oder R¹ ausgewählt aus Strukturen der oben genannten Formeln (13) bis (24). Dabei kann die emittierende Schicht fluoreszierend oder phosphoreszierend sein. Wenn die Verbindung als Elektronentransportmaterial eingesetzt wird, kann es bevorzugt sein, wenn sie dotiert ist, beispielsweise mit Alkalimetallkomplexen, wie z. B. Liq (Lithiumhydroxychinolinat).

In nochmals einer weiteren bevorzugten Ausführungsform der Erfindung wird die Verbindung gemäß Formel (1) bzw. Formel (2) bzw. gemäß den bevorzugten Ausführungsformen in einer Lochblockierschicht eingesetzt. Dabei ist bevorzugt mindestens ein Substituent R oder R¹ ausgewählt aus Strukturen der oben genannten Formeln (13) bis (24). Unter einer Lochblockierschicht wird eine Schicht verstanden, die auf Kathodenseite direkt an eine emittierende Schicht angrenzt, insbesondere in einer phosphoreszierenden Elektrolumineszenzvorrichtung.

Es ist weiterhin möglich, die Verbindung gemäß Formel (1) bzw. Formel (2) bzw. gemäß den bevorzugten Ausführungsformen sowohl in einer Lochblockierschicht bzw. Elektronentransportschicht als auch als Matrix in einer emittierenden Schicht zu verwenden. Dabei ist bevorzugt mindestens ein Substituent R oder R¹ ausgewählt aus Strukturen der oben genannten Formeln (13) bis (24).

In nochmals einer weiteren Ausführungsform der Erfindung wird die Verbindung gemäß Formel (1) bzw. Formel (2) bzw. gemäß den bevorzugten Ausführungsformen in einer Lochtransportschicht bzw. in einer Lochinjektionsschicht bzw. in einer Elektronenblockierschicht bzw. Exzitonenblockierschicht eingesetzt. Dabei ist bevorzugt mindestens ein Substituent R oder R¹ ausgewählt aus Strukturen der oben genannten Formeln (25) bis (42).

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen gemäß Formel (1) bzw. Formel (2) bzw. gemäß den bevorzugten Ausführungsformen einsetzen.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer oder höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Ink-Jet Druck (Tintenstrahldruck), LITI (Light Induced Thermal Imaging, Thermotransferdruck), Siebdruck, Flexodruck, Offsetdruck oder Nozzle-Printing hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Weiterhin sind Hybridverfahren möglich, bei denen beispielsweise eine oder mehrere Schichten aus Lösung aufgebracht werden und eine oder mehrere weitere Schichten aufgedampft werden. So ist es beispielsweise möglich, die emittierende Schicht aus Lösung aufzubringen und die Elektronentransportschicht aufzudampfen.

Ein weiterer Gegenstand der vorliegenden Anmeldung ist daher ein Verfahren zur Herstellung einer erfindungsgemäßen organischen Elektrolumineszenzvorrichtung, dadurch gekennzeichnet, dass mindestens eine Schicht durch ein Sublimationsverfahren aufgebracht wird oder dass mindestens eine Schicht durch das OVPD-Verfahren aufgebracht wird oder dass mindestens eine Schicht aus Lösung oder durch ein beliebiges Druckverfahren aufgebracht wird.

Die erfindungsgemäßen organischen Elektrolumineszenzvorrichtungen zeichnen sich durch folgende überraschende Vorteile gegenüber dem Stand der Technik aus:
1. Die erfindungsgemäße organische Elektrolumineszenzvorrichtung enthaltend Verbindungen gemäß Formel (1) bzw. Formel (2) als Matrixmaterial für fluoreszierende oder phosphoreszierende Emitter führen zu hohen Effizienzen sowie zu langen Lebensdauern. Dies gilt insbesondere, wenn die Verbindungen als Matrixmaterial für einen phosphoreszierenden Emitter eingesetzt werden.
2. Die Verbindungen gemäß Formel (1) bzw. Formel (2) weisen eine hohe thermische Stabilität auf, was für die Herstellung der erfindungsgemäßen organischen Elektrolumineszenzvorrichtung von Vorteil ist.
3. Organische Elektrolumineszenzvorrichtungen enthaltend Verbindungen gemäß Formel (1) bzw. Formel (2) führen zu hohen Effizienzen und zu steilen Strom-Spannungs-Kurven mit niedrigen Einsatzspannungen.
4. Auch bei Verwendung als Elektronentransportmaterial bzw. als Lochtransportmaterial führen die Verbindungen gemäß Formel (1) bzw. Formel (2) zu guten Eigenschaften in Bezug auf die Effizienz, die Lebensdauer und die Betriebsspannung von organischen Elektrolumineszenzvorrichtungen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

### Beispiele:

Die nachfolgenden Synthesen werden, sofern nicht anders angegeben, unter einer Schutzgasatmosphäre in getrockneten Lösungsmitteln durchgeführt. Die Lösungsmittel und Reagenzien können z. B. von Sigma-ALDRICH bzw. ABCR bezogen werden. Die Angaben in eckigen Klammern zu literaturbekannten chemischen Verbindungen beziehen sich auf die CAS-Nummer.

### Beispiel 1: Synthese der Bromide

### 1a) Synthese von 9-Brom-benzimidazo[2,1-a]isochinolin

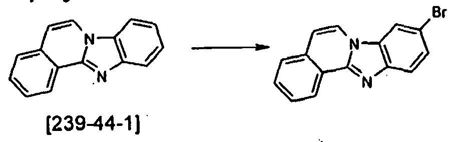

Eine Lösung von 40 g (183 mmol)) Benzimidazo[2,1-a]isochinolin in 500 ml THF wird mit 32.6 g (183 mmol) NBS versetzt und 4 h bei 60 °C gerührt. Anschließend wird die Lösung über Nacht bei Raumtemperatur gerührt, der Feststoff wird abgesaugt, mit Ethanol gewaschen und getrocknet. Ausbeute: 51.3 g (181 mmol), 98 %.

### 1b) Synthese von 5,9-Dibrom-benzimidazo[2,1-a]isoquinolin

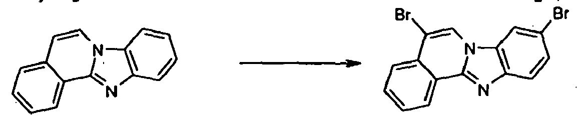

Eine Lösung von 38 g (174 mmol) Benzimidazo[2,1-a]isochinolin in 500 ml DMF wird mit 62 g (183 mmol) NBS versetzt und 4h bei 80 °C gerührt. Anschließend wird die Lösung über Nacht bei Raumtemperatur gerührt, der Feststoff wird abgesaugt, mit Ethanol gewaschen und getrocknet. Ausbeute: 52.4 g (139 mmol), 80 %.

### 1c) 5,9,11-Tribrom-benzimidazo[2,1-a]isochinoline

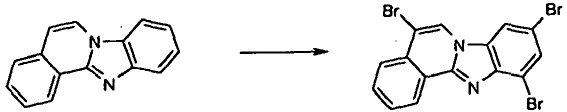

Eine Lösung von 40 g (183 mmol) Benzimidazo[2,1-a]isochinolin in 400 ml DMF wird mit 146.7 g (824 mmol) NBS versetzt und 4 h bei 120 °C gerührt. Anschließend wird die Lösung über Nacht bei Raumtemperatur gerührt, der Feststoff wird abgesaugt, mit Ethanol gewaschen und getrocknet. Ausbeute: 54 g (118 mmol), 65 %.

### Beispiel 2: Synthese der Boronsäurederivate

### 2a) Synthese von 9-(4,4,5,5-Tetramethyl-[1,3,2]dioxaborolan-2-yl)-benzo[4,5]imidazo[2,1-a]isochinolin

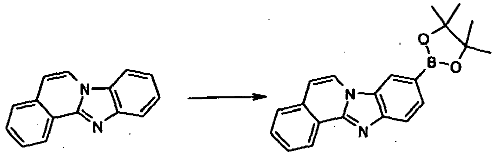

35 g (161 mmol) 9-Brom-benzimidazo[2,1-a]isochinolin, 53.3 g (210 mmol) Bis(pinacolato)diboran und 26 g (274 mmol) Kaliumacetat werden in 800 ml Dioxan suspendiert. Zu dieser Suspension werden 11.9 g (16.1 mmol) 1,1-Bis(diphenylphosphino)ferrocen-dichloropalladium(II) in Dichlormethan gegeben. Die Reaktionsmischung wird 16 h unter Rückfluss erhitzt. Nach Erkalten wird die organische Phase abgetrennt, dreimal mit 150 mL Wasser gewaschen und anschließend zur Trockene eingeengt. Der Rückstand wird aus Toluol umkristallisiert. Die Ausbeute beträgt 50.2 g (146 mmol, 91 %).

Analog werden die Verbindungen **2b** und **2c** erhalten:

| **Bsp**. | **Edukt 1** | **Produkt** | **Ausbeute** |
|---|---|---|---|
| **2b** | 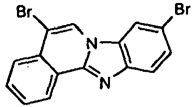 | 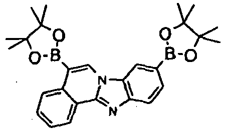 | 84 % |
| **2c** | 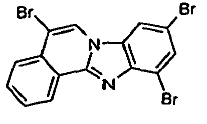 | 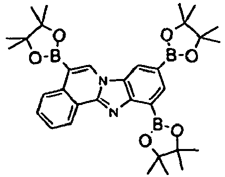 | 79% |

### Beispiel 3: Suzuki-Kupplung

### 3a) Synthese von 9-Biphenyl-2-yl-benzo[4,5]imidazo[2,1-a]isochinolin

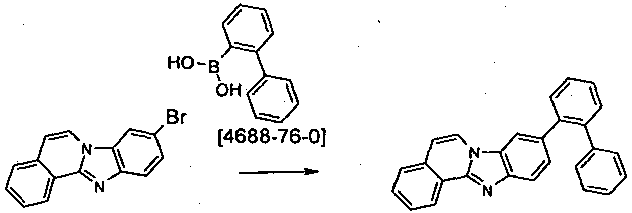

Eine gut gerührte Suspension von 14.8 g (50 mmol) 9-Brom-benzimidazo-[2,1-a]isochinolin, 9.9 g (55 mmol) 1,1'-Biphenyl-2-boronsäure und 25.5 g (120 mmol) Trikaliumphosphat in einem Gemisch aus 300 ml Toluol, 100 ml Dioxan und 400 ml Wasser wird mit 913 mg (3 mmol) Tri-o-tolylphosphin und dann mit 112 mg (0.5 mmol) Palladium(II)acetat versetzt und anschließend 16 h unter Rückfluss erhitzt. Nach Erkalten wird der ausgefallene Feststoff abgesaugt, dreimal mit 50 ml Toluol, dreimal mit 50 ml Ethanol: Wasser (1:1, v:v), dreimal mit 100 ml Ethanol gewaschen und abschließend getrocknet. Der Rückstand wird aus Toluol umkristallisiert. Die Ausbeute beträgt 17 g (45 mmol, 92 %).

Analog werden die Verbindunaen **3b - 3j** erhalten:

| **Bsp**. | **Edukt 1** | **Edukt 2** | **Produkt** | **Ausbeute** |
|---|---|---|---|---|
| **3b** | 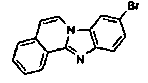 | 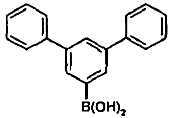 | 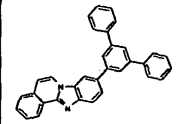 | 89% |
| | | [128388-54-5] | | |
| **3c** | 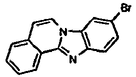 | 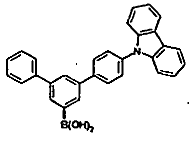 | 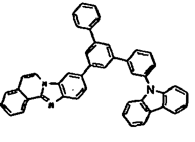 | 82 % |
| | | [784-42-4] | | |
| **3e** | 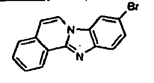 | 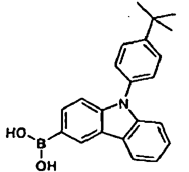 | 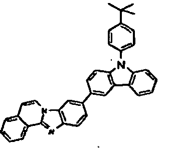 | 77% |
| | | [1133057-96-1] | | |
| **3f** | 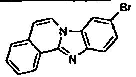 | 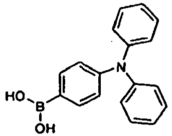 | 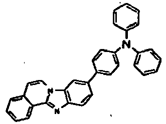 | 76% |
| | | [201802-67-7] | | |
| **3h** | 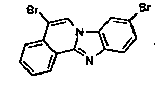 | 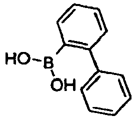 | 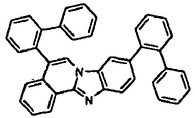 | 75% |
| | | [4688-76-0] | | |
| **3i** | 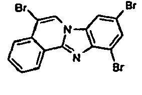 | 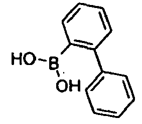 | 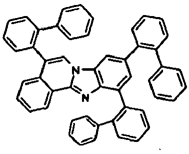 | 68% |
| **3j** | 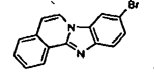 | 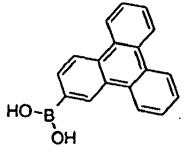 | 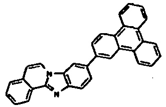 | 66% |
| | | [654664-63-8] | | |

### Beispiel 4: Synthese von 4-(2-Brom-phenyl)-2,6-diphenyl-pyrimidin

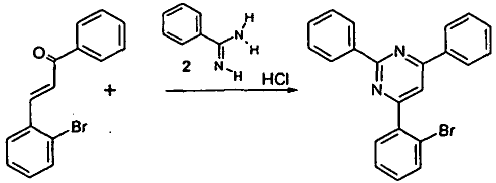

23 g (409 mmol) Kaliumhydroxid werden in 500 mL Ethanol gelöst, bei Raumtemperatur mit 40 g (255 mmol) Benzamidin-hydrochlorid **2** und 129 g (452 mmol) (3-(Bromphenyl)-1-phenyl-2-propen-1-on **1**, gelöst in 500 ml Ethanol, versetzt und 3 h unter Rückfluss gerührt. Nach Kühlung auf Raumtemperatur wird der ausgefallene Feststoff abgesaugt, mit etwas Ethanol gewaschen und getrocknet. Es verbleiben 55 g (129 mmol), 50 % des Produktes in Form farbloser Kristalle.

### Beispiel 5: Synthese von (3'-Brom-biphenyl-3-yl)-phenyl-methanon

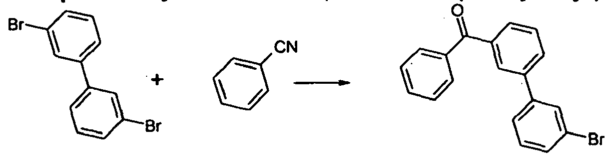

Aus einer Lösung von 31.5 g (101 mmol) 3,3'-Dibrom-biphenyl und 1 ml 1,2-Dichlorethan in 30 ml 1,2-Dimethoxyethan und 300 ml THF und 2.8 g (115 mmol) Magnesium wird in der Siedehitze das entsprechende Grignard-Reagenz hergestellt. Zu dieser Grignard-Lösung wird bei 0-5 °C eine Lösung von 10.4 g (101 mmol) Benzonitril in einer Mischung aus 130 ml THF und 130 ml Toluol während 20 min zugetropft. Anschließend wird die Mischung 16 h unter Rückfluss erhitzt. Nach Abkühlen wird die Reaktionsmischung bis zur Trockne eingeengt. Der Feststoff wird in 1000 ml NMP aufgenommen und mit 40 ml Wasser und 2 ml Eisessig 12 h auf Rückfluss erhitzt. Es wird eine Mischung aus 600 ml Methanol und 600 ml 1 N Salzsäure zugesetzt und der ausfallende Feststoff über Filtration abgetrennt und getrocknet. Das Rohprodukt wird aus Toluol/Heptan umkristallisiert. Die Ausbeute bei einer Reinheit > 98 % nach HPLC beträgt 27.1 g (80.5 mmol) entsprechend 80 % der Theorie.

### Beispiel 6: Synthese von Bis-(3'-brom-biphenyl-3-yl)-methanon

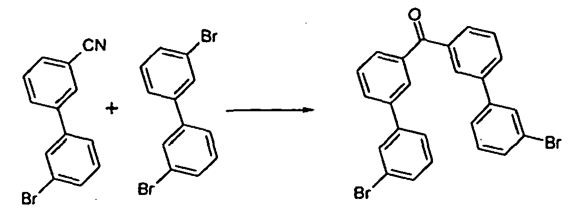

Aus einer Lösung von 31.5 g (101 mmol) 3,3'-Dibrom-biphenyl, 1 ml 1,2-Dichlorethan und 30 ml 1,2-Dimethoxyethan in 300 ml THF und 2.8 g (115 mmol) Magnesium wird in der Siedehitze das entsprechende Grignard-Reagenz hergestellt. Zu dieser Grignard-Lösung wird bei 0-5 °C eine Lösung von 26.06 g (101 mmol) 3-Brom-3'-cyano-biphenyl in einer Mischung aus 130 ml THF und 130 ml Toluol während 20 min. zugetropft. Anschließend wird die Mischung 16 h unter Rückfluss erhitzt. Nach Abkühlen wird die Reaktionsmischung bis zur Trockene eingeengt. Der Feststoff wird in 1100 ml NMP aufgenommen und mit 40 ml Wasser und 5 ml Eisessig 24 h auf Rückfluss erhitzt. Es wird eine Mischung aus 600 ml Methanol und 600 ml 1N Salzsäure zugesetzt und der ausfallende Feststoff über Filtration abgetrennt und getrocknet. Das Rohprodukt wird dreimal aus Toluol/Heptan umkristallisiert. Die Ausbeute bei einer Reinheit > 97 % nach HPLC beträgt 34.8 g (70.7 mmol) entsprechend 70 % der Theorie.

### Beispiel 7: 9-[3-(2,6-Diphenyl-pyrimidin-4-yl)-phenyl]benz[4,5]-imidazo[2,1-a]isochinolin

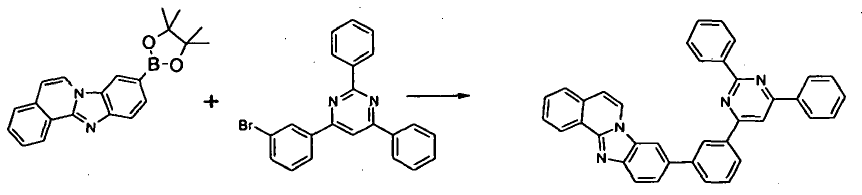

16 g (43.3 mmol) 2-(3-Bromphenyl)-4,6-diphenyl-pyrimidin und 16.5 g (48 mmol) 9-(4,4,5,5-Tetramethyl-[1,3,2]dioxaborolan-2-yl)-benz[4,5]imidazo-[2,1-a]isochinolin werden in 80 mL Toluol gelöst und entgast. Es wird mit 281 mL einer entgasten 2M K₂CO₃ und mit 2.5 g (2.2 mmol) Pd(OAc)₂ versetzt. Die Reaktionsmischung wird anschließend bei 80 °C für 48 h unter Schutzgasatmosphäre gerührt. Die abgekühlte Lösung wird mit Toluol aufgestockt, mehrmals mit Wasser gewaschen, getrocknet und eingeengt. Das Produkt wird via Säulenchromatographie an Kieselgel mit Toluol/Heptan (1:2) gereinigt. Die Reinheit beträgt 99.9 %. Ausbeute: 19.6 g (37 mmol) 77 % der Theorie.

Analog werden die Verbindungen **7a -** 7m erhalten:

| **Bsp.** | **Edukt 1** | **Edukt 2** | **Produkt** | **Ausbeute** |
|---|---|---|---|---|
| 7a | 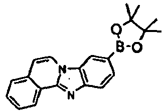 | 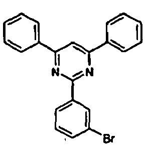 | 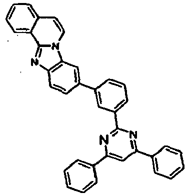 | 64% |
| | | [864377-28-6] | | |
| 7b | 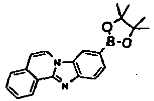 | 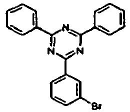 | 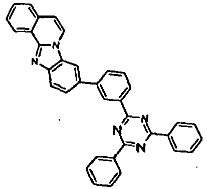 | 73% |
| | | [864377-31-1] | | |
| 7c | 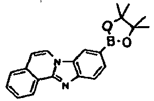 | 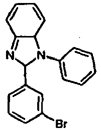 | 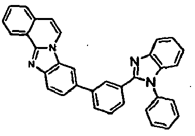 | 72% |
| | | [760212-40-6] | | |
| 7e | 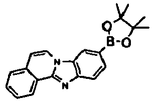 | 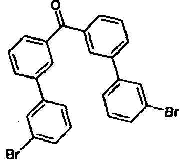 | 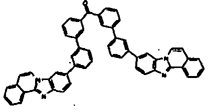 | 59% |
| 7f | 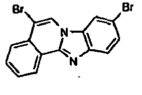 | 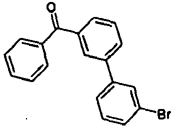 | 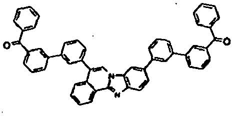 | 63% |
| 7h | 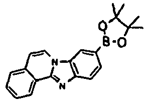 | 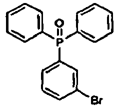 | 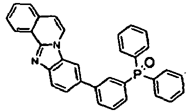 | 65% |
| | | [10212-04-1] | | |
| 7i | 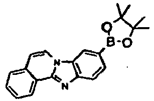 | 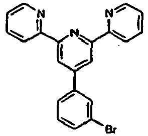 | 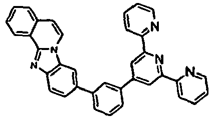 | 61% |
| | | [879879-65-9] | | |
| 7j | 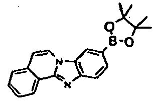 | 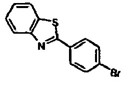 | 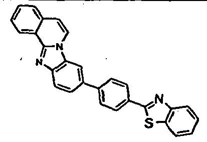 | 79% |
| | | [19654-19-4] | | |
| 7k | 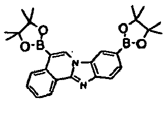 | 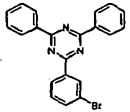 | 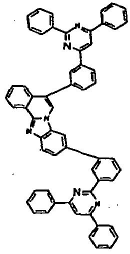 | 64% |
| | | [864377-31-1] | | |
| 7l | 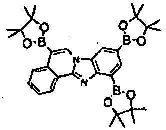 | 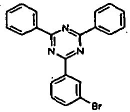 | 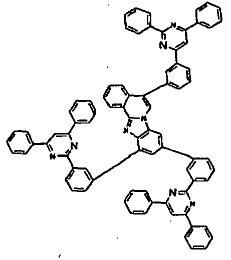 | 53% |
| | | [864377-31-1] | | |
| 7m | 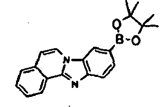 | 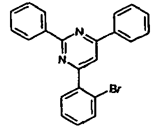 | 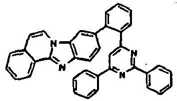 | 55% |

### Beispiel 8: 9-(9,9-Dimethyl-9H-acridin-10-yl)-benz[4,5]imidazo[2,1-a]-isochinolin

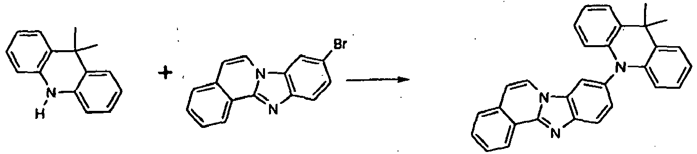

Unter Schutzgas werden 16.7 g (79.8 mmol) 9,10-Dihydro-9,9'dimethyl-acridin, 25 g (87 mmol) 9-Brom-benzimidazo[2,1-a]isochinolin und 15.9 ml (15.9 mmol) 1 mol/l Tri-tert-butylphosphin, 1.79 g (7.9 mmol) Palladiumacetat in 120 ml p-Xylol suspendiert. Die Reaktionsmischung wird 16 h unter Rückfluss erhitzt. Nach Erkalten wird die organische Phase abgetrennt, dreimal mit 200 mL Wasser gewaschen und anschließend zur Trockene eingeengt. Der Rückstand wird mit Toluol heiß extrahiert, aus Toluol umkristallisiert und abschließend im Hochvakuum sublimiert, die Reinheit beträgt 99.9 %. Ausbeute: 28 g (67 mmol, 80 %) der Theorie.

Analog werden die Verbindungen **8a - 8d** erhalten:

| **Bsp.** | **Edukt 1** | **Edukt 2** | **Produkt** | **Ausbeute** |
|---|---|---|---|---|
| **8a** | 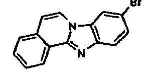 | 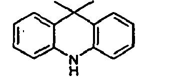 | 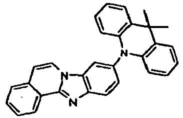 | 65% |
| | | [6267-02-3] | | |
| **8b** | 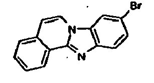 | 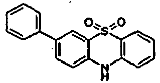 | 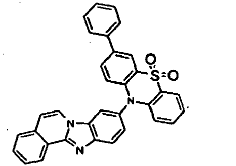 | 71% |
| | | [888008-94-4] | | |
| **8c** | 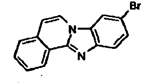 | 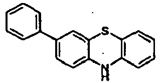 | 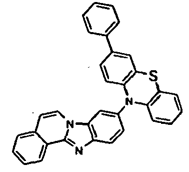 | 73% |
| | | [4018-68-2] | | |
| **8d** | 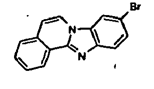 | 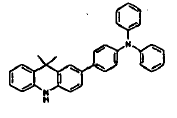 | 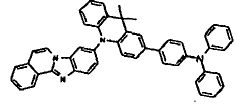 | 78% |
| | | [1236106-99-2] | | |

### Beispiel 9: Herstellung der OLEDs

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, Materialien) angepasst wird.

In den folgenden Beispielen E1 bis E13 (siehe Tabellen 1 und 2) werden die Daten verschiedener OLEDs vorgestellt. Glasplättchen, die mit strukturiertem ITO (Indium-Zinn-Oxid) der Dicke 50 oder 150 nm beschichtet sind, werden zur verbesserten Prozessierung mit 20 nm PEDOT beschichtet (Poly(3,4-ethylendioxy-2,5-thiophen), aus Wasser aufgeschleudert; bezogen von H. C. Starck, Gostar, Deutschland). Diese beschichteten Glasplättchen bilden die Substrate, auf welche die OLEDs aufgebracht werden. Die OLEDs haben prinzipiell folgenden Schichtaufbau: Substrat / optionale Lochinjektionsschicht (HIL) / Lochtransportschicht (HTL) / optionale Zwischenschicht (IL) / Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die grün emittierenden OLEDs werden auf 50 nm dickem ITO, die rot emittierenden OLEDs werden auf 150 nm dickem ITO gefertigt. Die zur Herstellung der OLEDs verwendeten Materialien sind in Tabelle 3 gezeigt. Die Verbindungen, die nicht in Tabelle 3 aufgeführt sind, sondern lediglich mit einer Nummer im Fettdruck bezeichnet sind, beziehen sich auf die Verbindungen der vorliegenden Erfindung, deren Synthese in den Beispielen 1 bis 8 beschrieben ist; die Nummer bezeichnet somit die Nummer des entsprechenden Synthesebeispiels.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie ST1:**3i**:TEG1 (30%:60%:10%) bedeutet hierbei, dass das Material ST1 in einem Volumenanteil von 30%, 3i in einem Anteil von 60% und TEG1 in einem Anteil von 10% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik bestimmt. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 2 bezeichnet die Spannung, die für eine Leuchtdichte von 1000 cd/m² benötigt wird. SE1000 und LE1000 bezeichnen die Strom- bzw. Leistungseffizienz, die bei 1000 cd/m² erreicht werden. EQE1000 schließlich bezeichnet die externe Quanteneffizienz bei einer Betriebsleuchtdichte von 1000 cd/m².

Die Daten der verschiedenen OLEDs sind in Tabelle 2 zusammengefasst. Im Folgenden werden einige dieser Beispiele näher erläutert, um die Vorteile der erfindungsgemäßen Verbindungen zu verdeutlichen. Es sei jedoch darauf hingewiesen, dass dies nur eine Auswahl der gezeigten Daten darstellt. Wie sich der Tabelle entnehmen lässt, werden auch bei Verwendung der nicht näher ausgeführten erfindungsgemäßen Verbindungen gute bis sehr gute Werte für Spannung und Effizienz erreicht.

### Verwendung von erfindungsgemäßen Verbindungen als Matrixmaterialien in phosphoreszierenden OLEDs

Die erfindungsgemäßen Materialien lassen sich entweder als Einzelmatrix (Beispiele E7 bis E10) bzw. in Kombination mit einem weiteren Matrixmaterial einsetzen ("Mixed Matrix", Beispiele E1 bis E4, E11 bis E13). Bei Verwendung von roten wie auch grünen phosphoreszenten Emittern erhält man gute bis sehr gute Leistungsdaten. Beispielsweise erhält man mit Verbindung 7 (also der Verbindung gemäß Beispiel 7) eine sehr gute externe Quanteneffizienz von fast 16% (Beispiel E7). Durch Mischung von ST1 mit der erfindungsgemäßen Verbindung 8a erhält man eine sehr niedrige Spannung von 3.5 V (Beispiel E4).

### Verwendung von erfindungsgemäßen Verbindungen als Elektronentransportmaterialien

Bei Einsatz der erfindungsgemäßen Verbindung **7b** in der Elektronentransportschicht benötigt man für 1000 cd/m² eine Spannung von nur 3.6 V. Bei dieser Leuchtdichte erhält man eine externe Quanteneffizienz von etwas über 16% (Beispiel E6). Betreibt man die OLED aus Beispiel E6 mit einer konstanten Stromdichte von 20 mA/cm², so fällt die anfängliche Leuchtdichte von 9700 cd/m² innerhalb von etwa 140 h auf 80%. Man erhält mit erfindungsgemäßen Verbindungen neben guter Spannung und Effizienz somit auch gute Lebensdauern.

**Tabelle 1: Aufbau der OLEDs**

| Bsp. | HIL Dicke | HTL Dicke | IL Dicke | EBL Dicke | EML Dicke | HBL Dicke | ETL Dicke | EIL Dicke |
|---|---|---|---|---|---|---|---|---|
| E1 | - | SpA1 70nm | HATCN 5nm | SpA2 90nm | ST1:3c:TEG1 (30%:60%:10%) 30nm | IC1 10nm | ST1:LiQ (50%:50%) 30nm | |
| E2 | - | SpA1 70nm | HATCN 5nm | SpA2 90nm | ST1:3i:TEG1 (30%:60%:10%) 30nm | IC1 10nm | ST1 :LiQ (50%:50%) 30 nm | - |
| E3 | - | SpA1 20nm | - | NPB 20nm | ST1:3j:TER1 (35%:50%:15%) 30nm | ST1 10nm | Alq₃ 20nm | LiF 1nm |
| E4 | - | SpA1 70nm | HATCN 5nm | SpA2 90nm | IC1:**8a**:TEG1 (65%:25%:10%) 30nm | IC1 10nm | ST1:LiQ (50%:50%) 30nm | - |
| E5 | SpA1 140nm | HATCN 5nm | NPB 10nm | **3f** 10nm | IC1:TEG1 (90%:10%) 30nm | - | ST2:LiQ (50%:50%) 40nm | - |
| E6 | - | SpA1 70nm | HATCN 5nm | SpA2 90nm | IC1.TEG1 (90%:10%) 30nm | - | **7b** 40nm | LiQ 3nm |
| E7 | - | SpA1 70nm | HATCN 5nm | SpA2 90nm | **7**:TEG1 (90%:10%) 30nm | - | ST1:LiQ (50%:50%) 40nm | - |
| E8 | - | SpA1 70nm | HATCN 5nm | SpA2 90nm | **7a**:TEG1 (90%: 10%) 30nm | - | ST1:LiQ (50%:50%) 40nm | - |
| E9 | - | SpA1 20nm | - | NPB 20nm | **7e:TE**R1 (85%:15%) 30nm | IC1 10nm | A1q₃ 20nm | LiF 1nm |
| . E10 | - | Span 20nm | - | NPB 20nm | **7h:TER**1 (85%:15%) 30nm | IC2 10nm | Alq₃ 20nm | LiF 1nm |
| E11 | - | SpA1 70nm | HATCN 5nm | SpA2 90nm | **ST1:7c:TEG**1 (30%:60%:10%) 30nm | IC1 10nm | ST1:LiQ (50%:50%) 30nm | - |
| E12 | - | SpA1 70nm | HATCN 5nm | SpA2 90nm | **7:IC3:TEG**1 (30%:60%:10%) 30nm | IC1 10nm | ST1:LiQ (50%:50%) 30nm | - |
| E13 | - | **Bd** 70nm | HATCN 5nm | SpA2 90nm | IC1:TEG1 (90%:10%) 30nm | - | ST2:LiQ (50%:50%) 40nm | - |

**Tabelle 2: Daten der OLEDs**

| **Bsp.** | U1000 (V) | SE1000 (cd/A) | LE1000 (Im/W) | EQE 1000 | CIE x/y bei 1000 cd/m² |
|---|---|---|---|---|---|
| E1 | 3.6 | 53 | 46 | 14.8% | 0.34/0.62 |
| E2 | 3.9 | 55 | 45 | 15.4% | 0.34/0.62 |
| E3 | 5.1 | 7.7 | 4.7 | 10.8% | 0.69/0.31 |
| E4 | 3.5 | 54 | 48 | 15.0% | 0.33/0.62 |
| E5 | 3.4 | 59 | 55 | 16.5% | 0.34/0.62 |
| E6 | 3.6 | 57 | 50 | 16.1% | 0.34/0.62 |
| E7 | 3.8 | 57 | 48 | 15.9% | 0.34/0.62 |
| E8 | 3.7 | 54 | 46 | 15.1% | 0.34/0.62 |
| E9 | 4.4 | 7.1 | 5.1 | 11.9% | 0.69/0.31 |
| E10 | 5.4 | 7.9 | 4.6 | 13.3% | 0.69/0.31 |
| E11 | 3.6 | 49 | 43 | 13.8% | 0.34/0.62 |
| E12 | 3.7 | 53 | 45 | 14.7% | 0.33/0.62 |
| E13 | 3.5 | 60 | 53 | 16.8% | 0.33/0.62 |

**Tabelle 3: Strukturformeln der Materialien für die OLEDs**

| | |
|---|---|
| 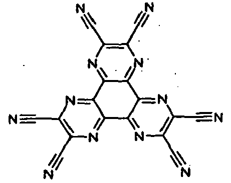 | 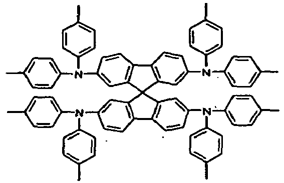 |
| HATCN | SpA1 |
| 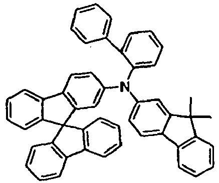 | 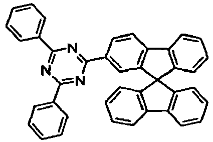 |
| SpA2 | ST1 |
| 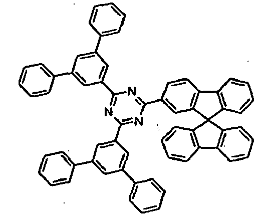 | 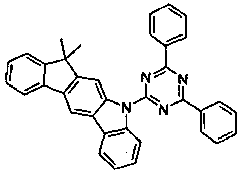 |
| ST2 | IC1 |
| 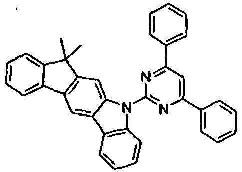 | 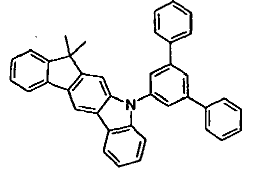 |
| IC2 | IC3 |
| 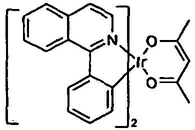 | 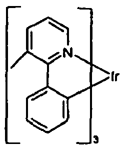 |
| TER1 | TEG1 |
| 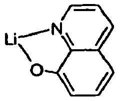 | 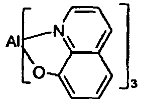 |
| LiQ | Alq₃ |

## Patentansprüche

1. Organische Elektrolumineszenzvorrichtung enthaltend mindestens eine Verbindung gemäß Formel (1) oder Formel (2), 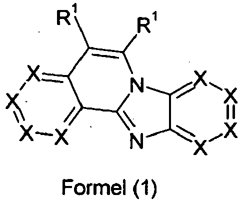 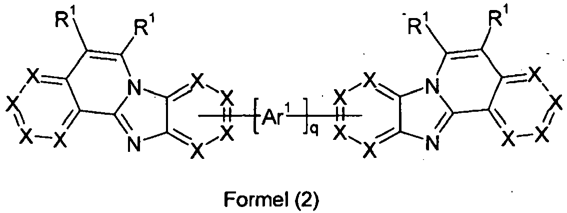 wobei für die verwendeten Symbole und Indizes gilt:
X ist bei jedem Auftreten gleich oder verschieden CR oder N, mit der Maßgabe, dass maximal zwei Gruppen X, die direkt aneinander gebunden sind, für N stehen;
R, R¹ ist bei jedem Auftreten gleich oder verschieden ausgewählt aus der Gruppe bestehend aus H, D, F, CI, Br, I, CN, NO₂, N(Ar)₂, N(R²)2, C(=O)Ar, C(=O)R², P(=O)(Ar)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten R² substituiert sein kann, wobei eine oder mehrere nicht-benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, CI, Br, l, CN oder NO₂ ersetzt sein können, einem aromatischen oder heteroaromatischen Ringsystem mit 5 bis 80, bevorzugt 5 bis 60, aromatischen Ringatomen, das jeweils mit einem oder mehreren Resten R² substituiert sein kann, einer Aryloxy- oder Heteroaryloxygruppe mit 5 bis 60 aromatischen Ringatomen, die mit einem oder mehreren Resten R² substituiert sein kann, oder einer Aralkyl- oder Heteroaralkylgruppe mit 5 bis 60 aromatischen Ringatomen, die mit einem oder mehreren Resten R² substituiert sein kann; dabei bilden benachbarte Reste R keinen Ring miteinander aus, und die Reste R¹ bilden keinen Ring miteinander aus;
Ar¹ ist gleich oder verschieden bei jedem Auftreten eine bivalente Aryl-oder Heteroarylgruppe mit 5 bis 18 C-Atomen, welche durch einen oder mehrere Reste R² substituiert sein kann;
R² ist bei jedem Auftreten gleich oder verschieden ausgewählt aus der Gruppe bestehend aus H, D, F, Cl, Br, I, CN, NO₂, N(Ar)₂, N(R³)₂, C(=O)Ar, C(=O)R³, P(=O)(Ar)₂, einer geradkettigen Alkyl-, Alkoxy-oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten R³ substituiert sein kann, wobei eine oder mehrere nicht-benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch D, F, CI, Br, l, CN oder NO₂ ersetzt sein können, einem aromatischen oder heteroaromatischen Ringsystem mit 5 bis 60 aromatischen Ringatomen, das jeweils mit einem oder mehreren Resten R³ substituiert sein kann, einer Aryloxy- oder Heteroaryloxygruppe mit 5 bis 60 aromatischen Ringatomen, die mit einem oder mehreren Resten R³ substituiert sein kann, oder eine Aralkyl-oder Heteroaralkylgruppe mit 5 bis 60 aromatischen Ringatomen, wobei optional zwei oder mehr benachbarte Substituenten R² ein monocyclisches oder polycyclisches, aliphatisches, aromatisches oder heteroaromatisches Ringsystem bilden können, das mit einem oder mehreren Resten R³ substituiert sein kann;
Ar ist bei jedem Auftreten gleich oder verschieden ein aromatisches oder heteroaromatisches Ringsystem mit 5-30 aromatischen Ringatomen, das mit einem oder mehreren nicht-aromatischen Resten R³ substituiert sein kann; dabei können zwei Reste Ar, welche an dasselbe N-Atom oder P-Atom binden, auch durch eine Einfachbindung oder eine Brücke, ausgewählt aus N(R³), C(R³)₂, O oder S, miteinander verbrückt sein;
R³ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, CI, Br, I oder CN ersetzt sein können, wobei zwei oder mehr benachbarte Substituenten R³ miteinander ein mono- oder polycyclisches, aliphatisches, aromatisches oder heteroaromatisches Ringsystem bilden können;
q ist bei jedem Auftreten gleich oder verschieden 0, 1, 2 oder 3.

2. Organische Elektrolumineszenzvorrichtung nach Anspruch 1, **dadurch gekennzeichnet, dass** in jedem Cyclus maximal eine Gruppe X für N steht und die anderen Gruppen X gleich oder verschieden bei jedem Auftreten für CR stehen.

3. Organische Elektrolumineszenzvorrichtung nach Anspruch 1 oder 2, **dadurch gekennzeichnet, dass** die Verbindung der Formel (1) ausgewählt ist aus den Strukturen der Formeln (3) bis (11) und dass die Verbindung der Formel (2) ausgewählt ist aus den Strukturen der Formel (12), 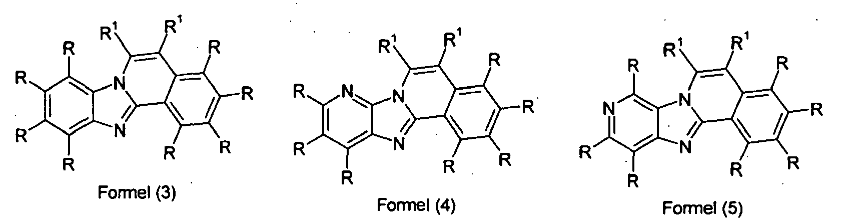 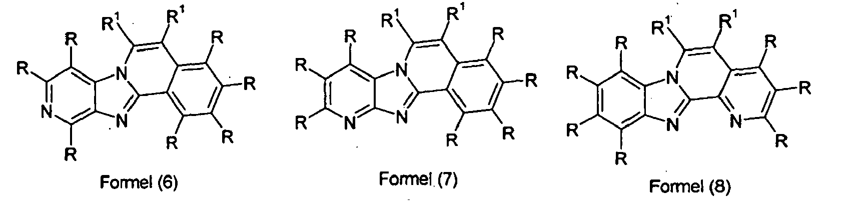 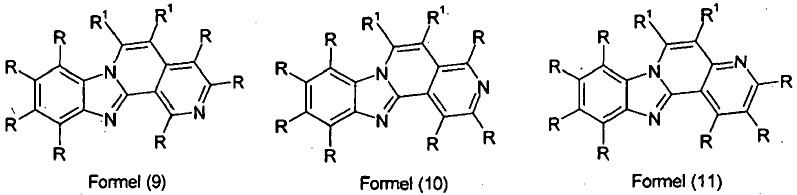 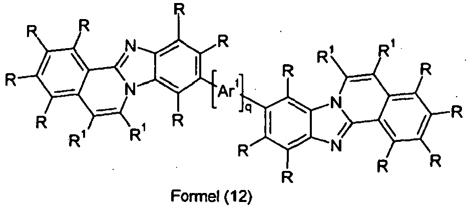 wobei die verwendeten Symbole und Indizes die in Anspruch 1 genannten Bedeutungen aufweisen.

4. Organische Elektrolumineszenzvorrichtung nach einem oder mehreren der Ansprüche 1 bis 3, **dadurch gekennzeichnet, dass** in der Verbindung der Formel (1) oder (2) mindestens eine Gruppe R und/oder R¹ ungleich H oder D ist.

5. Organische Elektrolumineszenzvorrichtung nach einem oder mehreren der Ansprüche 1 bis 4, **dadurch gekennzeichnet, dass** die Verbindung gemäß Formel (1) ausgewählt ist aus den Verbindungen der Formeln (3a) bis (3i), 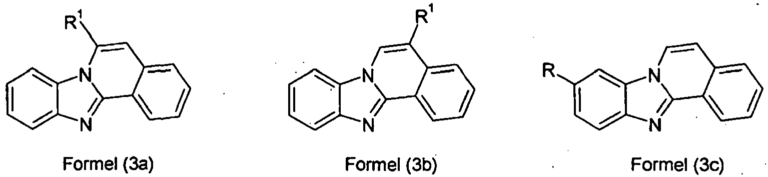 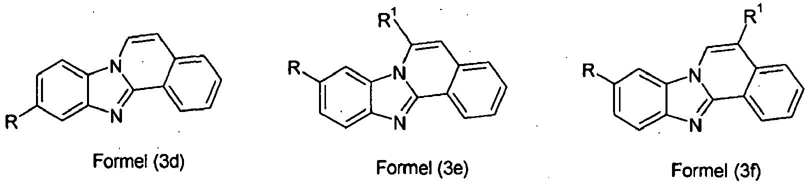 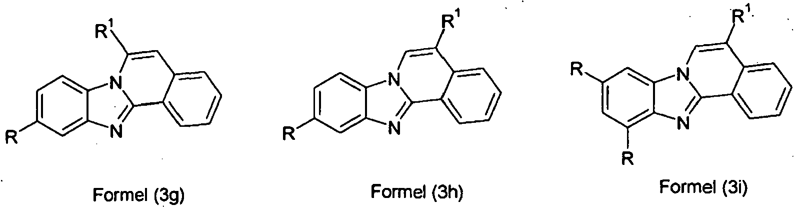 wobei die verwendeten Symbole die in Anspruch 1 genannten Bedeutungen aufweisen und R und R¹ ungleich H oder D sind.

6. Organische Elektrolumineszenzvorrichtung nach einem oder mehreren der Ansprüche 1 bis 5, **dadurch gekennzeichnet, dass** R bzw. R¹ bei jedem Auftreten gleich oder verschieden ausgewählt ist aus der Gruppe bestehend aus H, D, F, CN, N(Ar)₂, C(=O)Ar, P(=O)(Ar)₂, einer geradkettigen Alkylgruppe mit 1 bis 10 C-Atomen oder einer verzweigten oder cyclischen Alkylgruppe mit 3 bis 10 C-Atomen oder einer Alkenylgruppe mit 2 bis 10 C-Atomen, die jeweils mit einem oder mehreren Resten R² substituiert sein kann, wobei eine oder mehrere nicht-benachbarte CH₂-Gruppen durch O oder S ersetzt sein können und wobei ein oder mehrere H-Atome durch D oder F ersetzt sein können, einem aromatischen oder heteroaromatischen Ringsystem mit 6 bis 30 aromatischen Ringatomen, das jeweils mit einem oder mehreren Resten R² substituiert sein kann.

7. Organische Elektrolumineszenzvorrichtung nach einem oder mehreren der Ansprüche 1 bis 6, **dadurch gekennzeichnet, dass** mindestens ein Substituent R und/oder R¹ ausgewählt ist aus Strukturen gemäß den Formeln (13) bis (17), 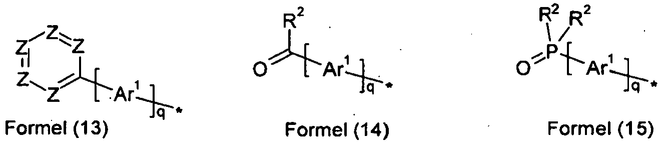 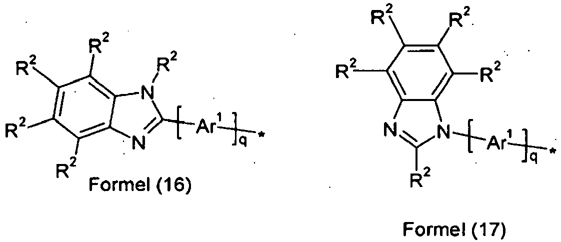 wobei die Symbole und Indizes die in Anspruch 1 genannten Bedeutungen haben, * die Position der Bindung an den Grundkörper der Formel (1) bzw. Formel (2) andeutet und weiterhin gilt:
Z ist bei jedem Auftreten gleich oder verschieden CR² oder N, mit der Maßgabe, dass eine Gruppe Z, zwei Gruppen Z oder drei Gruppen Z für N stehen.

8. Organische Elektrolumineszenzvorrichtung nach Anspruch 7, **dadurch gekennzeichnet, dass** mindestens ein Substituent R oder R¹ ausgewählt ist aus den Gruppen der Formeln (18) bis (24), 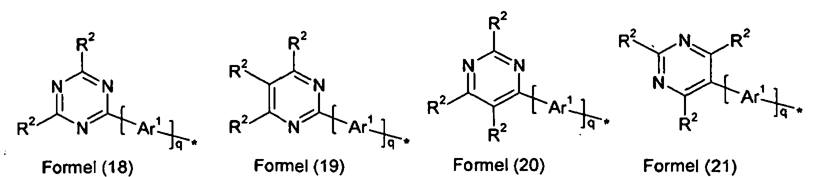 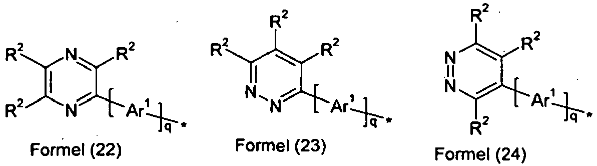 wobei die verwendeten Symbole und Indizes die in Anspruch 1 genannten Bedeutungen aufweisen.

9. Organische Elektrolumineszenzvorrichtung nach einem oder mehreren der Ansprüche 1 bis 8, **dadurch gekennzeichnet, dass** mindestens ein Substituent R oder R¹ ausgewählt ist aus der Gruppe bestehend aus -NAr₂, Triarylaminderivaten, Carbazolderivaten, Indenocarbazolderivaten, Indolocarbazolderivaten, Azacarbazolderivaten, Indolderivaten, Furanderivaten, Benzofuranderivaten, Dibenzofuranderivaten, Thiophenderivaten, Benzothiophenderivaten oder Dibenzothiophenderivaten, welche jeweils durch einen oder mehrere Reste R² substituiert sein können.

10. Organische Elektrolumineszenzvorrichtung nach Anspruch 9, **dadurch gekennzeichnet, dass** mindestens ein Substituent R oder R¹ ausgewählt ist aus den Gruppen der Formeln (25) bis (42), 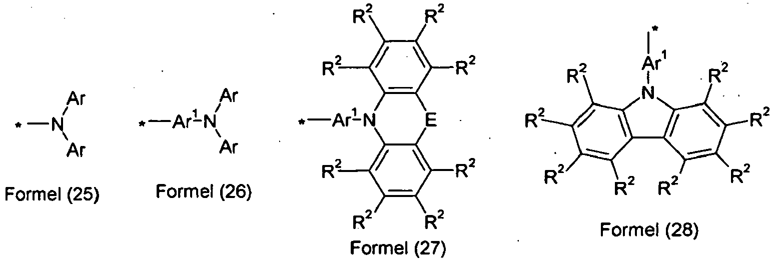 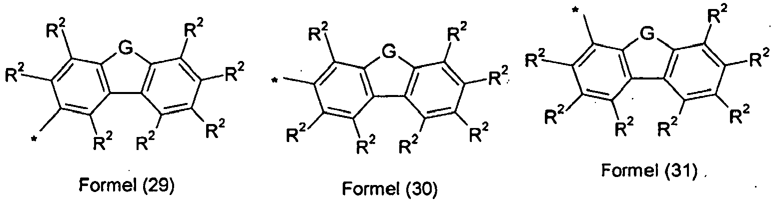 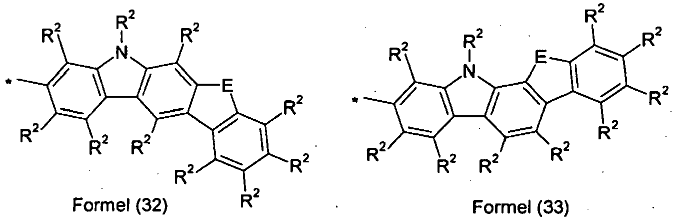 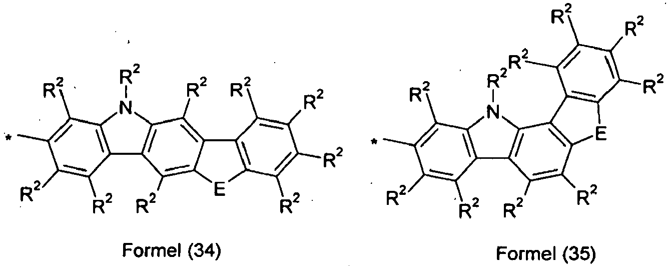 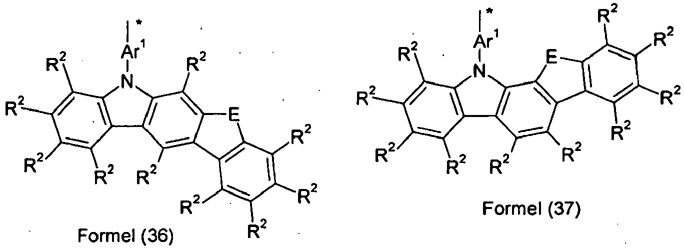 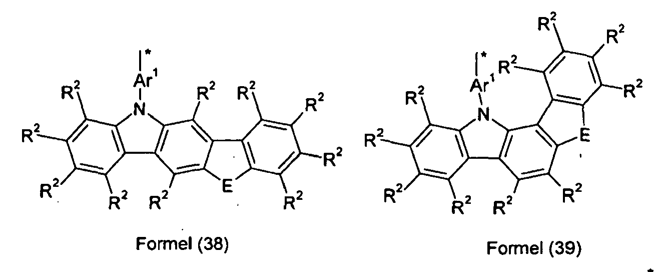 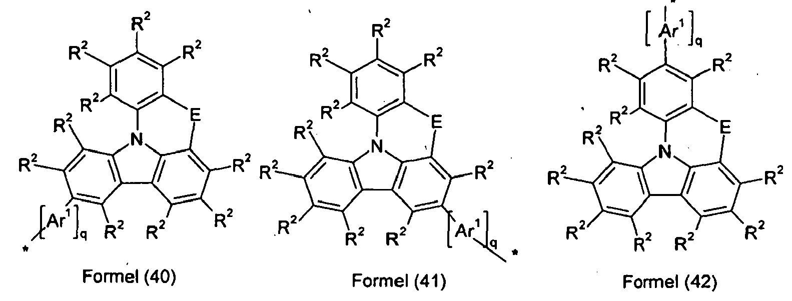 wobei die verwendeten Symbole die oben genannten Bedeutungen aufweisen und weiterhin gilt:
E ist ausgewählt aus der Gruppe bestehend aus C(R²)₂, NR², O oder S;
G ist ausgewählt aus der Gruppe bestehend aus NR², O oder S.

11. Organische Elektrolumineszenzvorrichtung nach einem oder mehreren der Ansprüche 1 bis 10, **dadurch gekennzeichnet, dass** die Verbindung gemäß Formel (1) oder Formel (2) als Matrixmaterial für eine fluoreszierende oder phosphoreszierende Verbindung, insbesondere für eine phosphoreszierende Verbindung, in einer emittierenden Schicht eingesetzt wird und/oder dass die Verbindung gemäß Formel (1) oder Formel (2) als Elektronentransportmaterial in einer Elektronentransport- oder Elektroneninjektionsschicht eingesetzt wird und/oder dass die Verbindung gemäß Formel (1) oder Formel (2) in einer Lochblockierschicht eingesetzt wird und/oder dass die Verbindung gemäß Formel (1) oder Formel (2) in einer Lochtransportschicht bzw. in einer Lochinjektionsschicht bzw. in einer Elektronenblockierschicht bzw. Exzitonenblockierschicht eingesetzt wird.

12. Verfahren zur Herstellung einer organischen Elektrolumineszenzvorrichtung nach einem oder mehreren der Ansprüche 1 bis 10, **dadurch gekennzeichnet, dass** mindestens eine Schicht durch ein Sublimationsverfahren aufgebracht wird oder dass mindestens eine Schicht durch das OVPD-Verfahren aufgebracht wird oder dass mindestens eine Schicht aus Lösung oder durch ein Druckverfahren aufgebracht wird.

## Claims

1. Organic electroluminescent device comprising at least one compound of the formula (1) or formula (2), 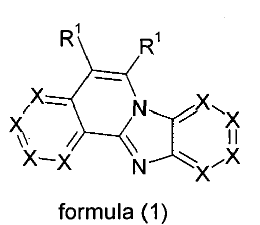 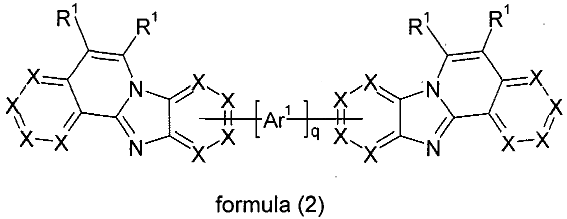 where the following applies to the symbols and indices used:
X is on each occurrence, identically or differently, CR or N, with the proviso that a maximum of two groups X which are bonded directly to one another stand for N;
R, R¹ are selected on each occurrence, identically or differently, from the group consisting of H, D, F, Cl, Br, I, CN, NO₂, N(Ar)₂, N(R²)₂, C(=O)Ar, C(=O)R², P(=O)(Ar)₂, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, each of which may be substituted by one or more radicals R², where one or more non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, an aromatic or heteroaromatic ring system having 5 to 80, preferably 5 to 60, aromatic ring atoms, which may in each case be substituted by one or more radicals R², an aryloxy or heteroaryloxy group having 5 to 60 aromatic ring atoms, which may be substituted by one or more radicals R², or an aralkyl or heteroaralkyl group having 5 to 60 aromatic ring atoms, which may be substituted by one or more radicals R²; adjacent radicals R do not form a ring with one another here, and the radicals R1 do not form a ring with one another;
Ar¹ is, identically or differently on each occurrence, a divalent aryl or heteroaryl group having 5 to 18 C atoms, which may be substituted by one or more radicals R²;
R² is selected on each occurrence, identically or differently, from the group consisting of H, D, F, Cl, Br, I, CN, NO₂, N(Ar)₂, N(R³)₂, C(=O)Ar, C(=O)R³, P(=O)(Ar)₂, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, each of which may be substituted by one or more radicals R³, where one or more non-adjacent CH₂ groups may be replaced by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³ and where one or more H atoms may be replaced by D, F, Cl, Br, I, CN or NO₂, an aromatic or heteroaromatic ring system having 5 to 60 aromatic ring atoms, which may in each case be substituted by one or more radicals R³, an aryloxy or heteroaryloxy group having 5 to 60 aromatic ring atoms, which may be substituted by one or more radicals R³, or an aralkyl or heteroaralkyl group having 5 to 60 aromatic ring atoms, where two or more adjacent substituents R² may optionally form a monocyclic or polycyclic, aliphatic, aromatic or heteroaromatic ring system, which may be substituted by one or more radicals R³;
Ar is on each occurrence, identically or differently, an aromatic or heteroaromatic ring system having 5-30 aromatic ring atoms, which may be substituted by one or more non-aromatic radicals R³; two radicals Ar here which are bonded to the same N atom or P atom may also be bridged to one another by a single bond or a bridge selected from N(R³), C(R³)₂, O or S;
R³ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents R³ may form a mono- or polycyclic, aliphatic, aromatic or heteroaromatic ring system with one another;
q is on each occurrence, identically or differently, 0, 1, 2 or 3.

2. Organic electroluminescent device according to Claim 1, **characterised in that** a maximum of one group X in each ring stands for N and the other groups X stand, identically or differently on each occurrence, for CR.

3. Organic electroluminescent device according to Claim 1 or 2, **characterised in that** the compound of the formula (1) is selected from the structures of the formulae (3) to (11) and **in that** the compound of the formula (2) is selected from the structures of the formula (12), 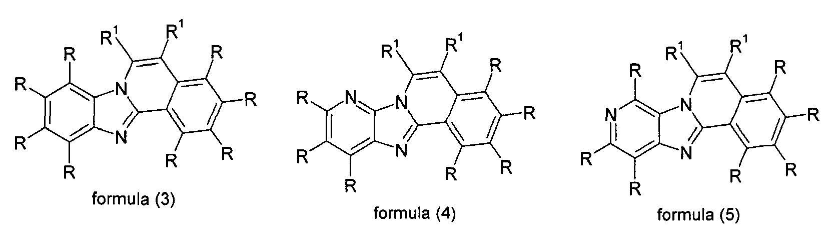 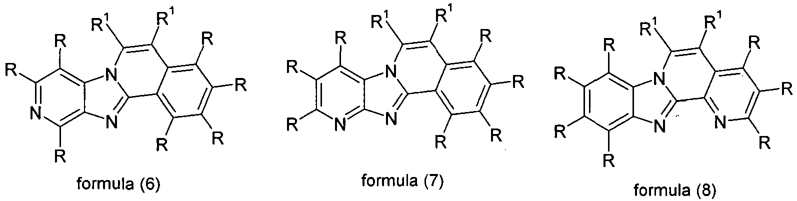 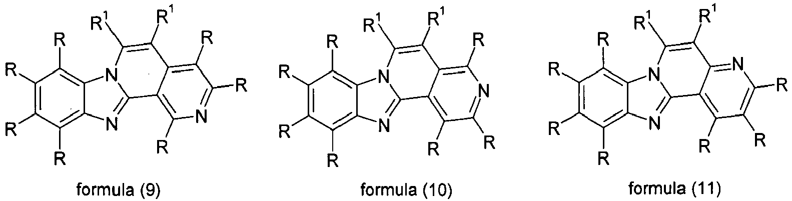 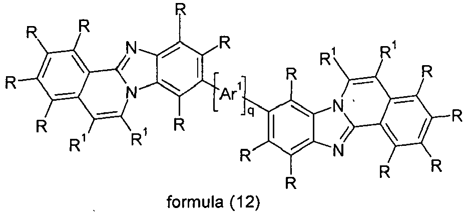 where the symbols and indices used have the meanings given in Claim 1.

4. Organic electroluminescent device according to one or more of Claims 1 to 3, **characterised in that** at least one group R and/or R¹ in the compound of the formula (1) or (2) is not equal to H or D.

5. Organic electroluminescent device according to one or more of Claims 1 to 4, **characterised in that** the compound of the formula (1) is selected from the compounds of the formulae (3a) to (3i), 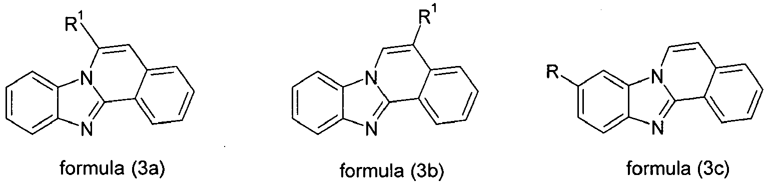 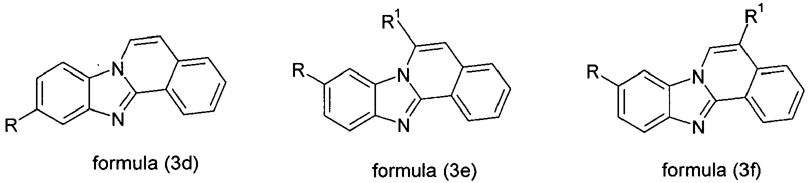 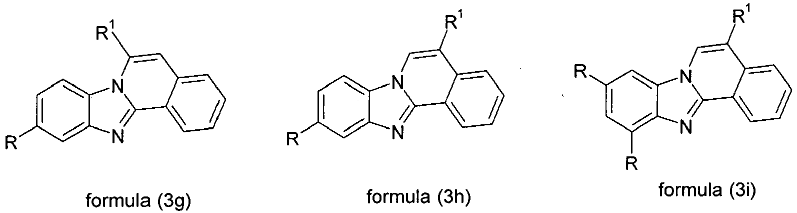 where the symbols used have the meanings given in Claim 1 and R and R¹ are not equal to H or D.

6. Organic electroluminescent device according to one or more of Claims 1 to 5, **characterised in that** R or R¹ is selected on each occurrence, identically or differently, from the group consisting of H, D, F, CN, N(Ar)₂, C(=O)Ar, P(=O)(Ar)₂, a straight-chain alkyl group having 1 to 10 C atoms or a branched or cyclic alkyl group having 3 to 10 C atoms or an alkenyl group having 2 to 10 C atoms, each of which may be substituted by one or more radicals R², where one or more non-adjacent CH₂ groups may be replaced by O or S and where one or more H atoms may be replaced by D or F, an aromatic or heteroaromatic ring system having 6 to 30 aromatic ring atoms, which may in each case be substituted by one or more radicals R².

7. Organic electroluminescent device according to one or more of Claims 1 to 6, **characterised in that** at least one substituent R and/or R¹ is selected from structures of the formulae (13) to (17), 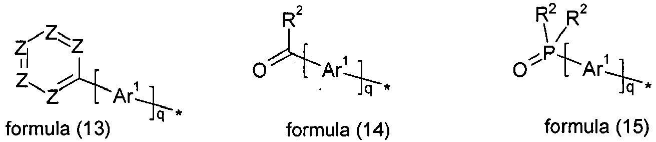 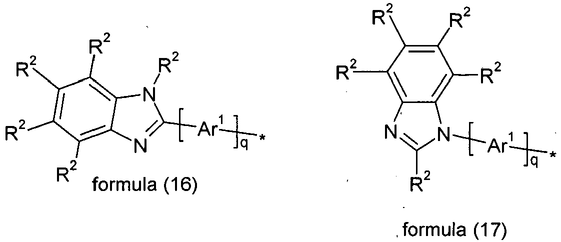 where the symbols and indices have the meanings given in Claim 1, * indicates the position of the bond to the basic structure of the formula (1) or formula (2) and furthermore:
Z is on each occurrence, identically or differently, CR² or N, with the proviso that one group Z, two groups Z or three groups Z stand for N.

8. Organic electroluminescent device according to Claim 7, **characterised in that** at least one substituent R or R¹ is selected from the groups of the formulae (18) to (24), 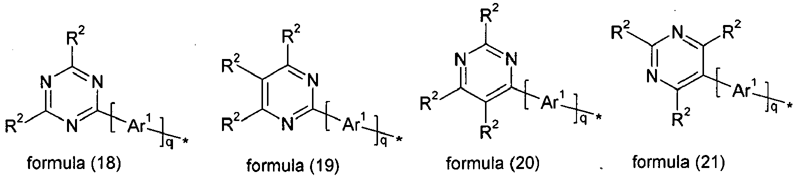 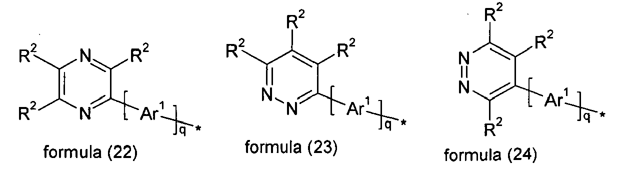 where the symbols and indices used have the meanings given in Claim 1.

9. Organic electroluminescent device according to one or more of Claims 1 to 8, **characterised in that** at least one substituent R or R¹ is selected from the group consisting of -NAr₂, triarylamine derivatives, carbazole derivatives, indenocarbazole derivatives, indolocarbazole derivatives, azacarbazole derivatives, indole derivatives, furan derivatives, benzofuran derivatives, dibenzofuran derivatives, thiophene derivatives, benzothiophene derivatives or dibenzothiophene derivatives, each of which may be substituted by one or more radicals R².

10. Organic electroluminescent device according to Claim 9, **characterised in that** at least one substituent R or R¹ is selected from the groups of the formulae (25) to (42), 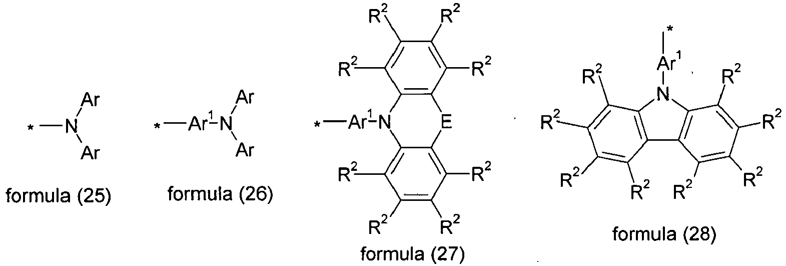 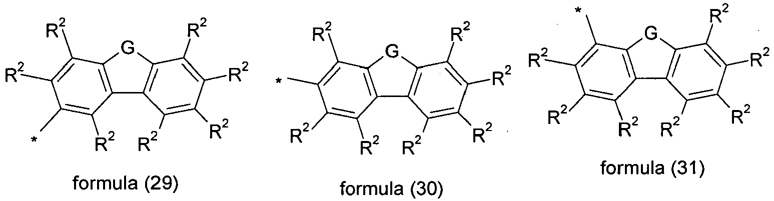 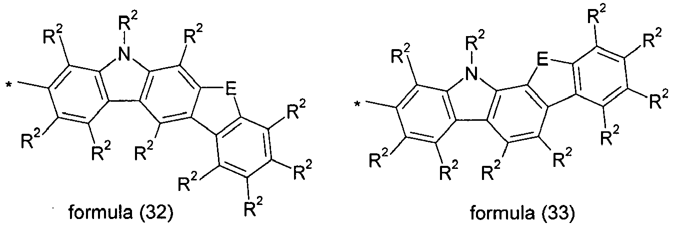 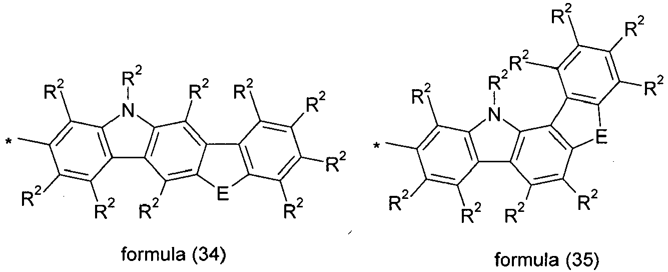 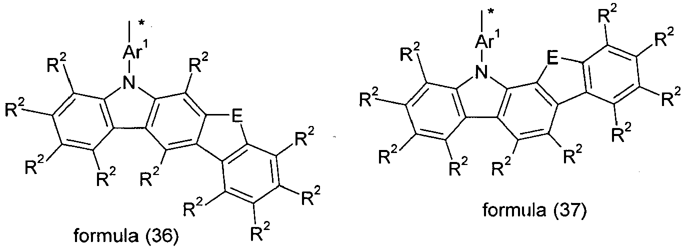 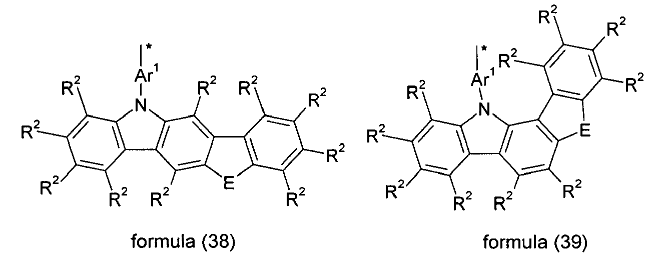 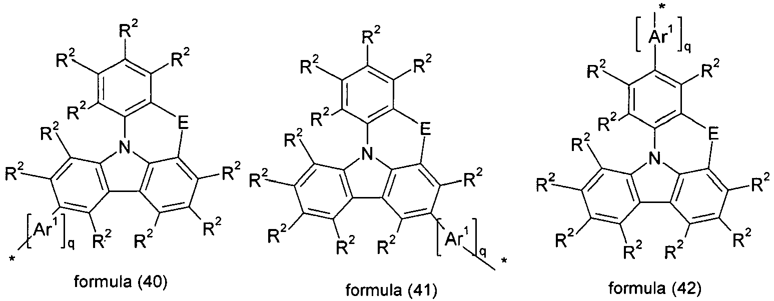 where the symbols used have the meanings given above and furthermore:
E is selected from the group consisting of C(R²)₂, NR², O or S;
G is selected from the group consisting of NR², O or S.

11. Organic electroluminescent device according to one or more of Claims 1 to 10, **characterised in that** the compound of the formula (1) or formula (2) is employed as matrix material for a fluorescent or phosphorescent compound, in particular for a phosphorescent compound, in an emitting layer and/or **in that** the compound of the formula (1) or formula (2) is employed as electron-transport material in an electron-transport or electron-injection layer and/or **in that** the compound of the formula (1) or formula (2) is employed in a hole-blocking layer and/or **in that** the compound of the formula (1) or formula (2) is employed in a hole-transport layer or in a hole-injection layer or in an electron-blocking layer or exciton-blocking layer.

12. Process for the production of an organic electroluminescent device according to one or more of Claims 1 to 10, **characterised in that** at least one layer is applied by a sublimation process or **in that** at least one layer is applied by the OVPD process or **in that** at least one layer is applied from solution or by a printing process.

## Revendications

1. Dispositif électroluminescent organique comprenant au moins un composé de la formule (1) ou de la formule (2) : 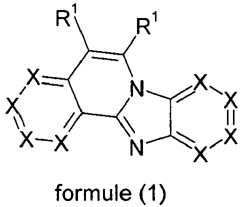 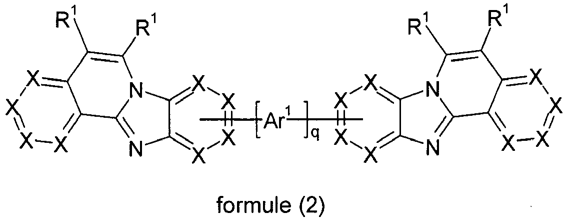 dans lesquelles ce qui suit s'applique aux symboles et indices utilisés :
X est, pour chaque occurrence, de manière identique ou différente, CR ou N, étant entendu qu'au maximum deux groupes X qui sont liés directement l'un à l'autre représentent N ;
R, R¹ sont choisis, pour chaque occurrence, de manière identique ou différente, parmi le groupe constitué par H, D, F, Cl, Br, I, CN, NO₂, N(Ar)₂, N(R²)₂, C(=O)Ar, C(=O)R², P(=O)(Ar)₂, un groupe alkyle, alcoxy ou thioalkyle en chaîne droite comportant 1 à 40 atome(s) de C ou un groupe alkyle, alcoxy ou thioalkyle ramifié ou cyclique comportant 3 à 40 atomes de C ou un groupe alkényle ou alkynyle comportant 2 à 40 atomes de C, dont chacun peut être substitué par un radical ou plusieurs radicaux R², où un ou plusieurs groupe(s) CH₂ non adjacents peut/peuvent être remplacé(s) par R²C=CR², C≡C, Si(R²)₂, Ge(R²)₂, Sn(R²)₂, C=O, C=S, C=Se, C=NR², P(=O)(R²), SO, SO₂, NR², O, S ou CONR² et où un ou plusieurs atome(s) de H peut/peuvent être remplacé(s) par D, F, Cl, Br, I, CN ou NO₂, un système de cycle aromatique ou hétéroaromatique comportant 5 à 80, de façon préférable 5 à 60, atomes de cycle aromatique, lequel peut dans chaque cas être substitué par un radical ou plusieurs radicaux R², un groupe aryloxy ou hétéroaryloxy comportant 5 à 60 atomes de cycle aromatique, lequel peut être substitué par un radical ou plusieurs radicaux R², ou un groupe aralkyle ou hétéroaralkyle comportant 5 à 60 atomes de cycle aromatique, lequel peut être substitué par un radical ou plusieurs radicaux R² ; des radicaux R adjacents ne forment pas ici un cycle les uns avec les autres, et les radicaux R1 ne forment pas un cycle les uns avec les autres ;
Ar¹ est, de manière identique ou différente pour chaque occurrence, un groupe aryle ou hétéroaryle divalent comportant 5 à 18 atomes de C, lequel peut être substitué par un radical ou plusieurs radicaux R² ;
R² est choisi, pour chaque occurrence, de manière identique ou différente, parmi le group constitué par H, D, F, Cl, Br, I, CN, NO₂, N(Ar)₂, N(R³)₂, C(=O)Ar, C(=O)R³, P(=O)(Ar)₂, un groupe alkyle, alcoxy ou thioalkyle en chaîne droite comportant 1 à 40 atome(s) de C ou un groupe alkyle, alcoxy ou thioalkyle ramifié ou cyclique comportant 3 à 40 atomes de C ou un groupe alkényle ou alkynyle comportant 2 à 40 atomes de C, dont chacun peut être substitué par un radical ou plusieurs radicaux R³, où un ou plusieurs groupe(s) CH₂ non adjacents peut/peuvent être remplacé(s) par R³C=CR³, C≡C, Si(R³)₂, Ge(R³)₂, Sn(R³)₂, C=O, C=S, C=Se, C=NR³, P(=O)(R³), SO, SO₂, NR³, O, S ou CONR³ et où un ou plusieurs atome(s) de H peut/peuvent être remplacé(s) par D, F, Cl, Br, I, CN ou NO₂, un système de cycle aromatique ou hétéroaromatique comportant 5 à 60 atomes de cycle aromatique, lequel peut dans chaque cas être substitué par un radical ou plusieurs radicaux R³, un groupe aryloxy ou hétéroaryloxy comportant 5 à 60 atomes de cycle aromatique, lequel peut être substitué par un radical ou plusieurs radicaux R³, ou un groupe aralkyle ou hétéroaralkyle comportant 5 à 60 atomes de cycle aromatique, où deux substituants R² adjacents ou plus peuvent en option former un système de cycle aliphatique, aromatique ou hétéroaromatique monocyclique ou polycyclique, lequel peut être substitué par un radical ou plusieurs radicaux R³ ;
Ar est, pour chaque occurrence, de manière identique ou différente, un système de cycle aromatique ou hétéroaromatique comportant 5-30 atomes de cycle aromatique, lequel peut être substitué par un radical ou plusieurs radicaux non aromatique(s) R³ ; deux radicaux Ar qui sont ici liés au même atome de N ou de P peuvent également être pontés l'un à l'autre par une liaison simple ou un pont choisi parmi N(R³), C(R³)₂, O ou S ;
R³ est choisi parmi le groupe constitué par H, D, F, CN, un radical hydrocarbone aliphatique comportant 1 à 20 atome(s) de C, un système de cycle aromatique ou hétéroaromatique comportant 5 à 30 atomes de cycle aromatique, où un ou plusieurs atome(s) de H peut/peuvent être remplacé(s) par D, F, Cl, Br, I ou CN, où deux substituants adjacents R³ ou plus peuvent former un système de cycle aliphatique, aromatique ou hétéroaromatique monocyclique ou polycyclique l'un avec l'autre ou les uns avec les autres ;
q est, pour chaque occurrence, de manière identique ou différente, 0, 1, 2 ou 3.

2. Dispositif électroluminescent organique selon la revendication 1, **caractérisé en ce qu'**au maximum un seul groupe X dans chaque cycle représente N et les autres groupes X représentent, de manière identique ou différente pour chaque occurrence, CR.

3. Dispositif électroluminescent organique selon la revendication 1 ou 2, **caractérisé en ce que** le composé de la formule (1) est choisi parmi les structures des formules (3) à (11) et **en ce que** le composé de la formule (2) est choisi parmi les structures de la formule (12) : 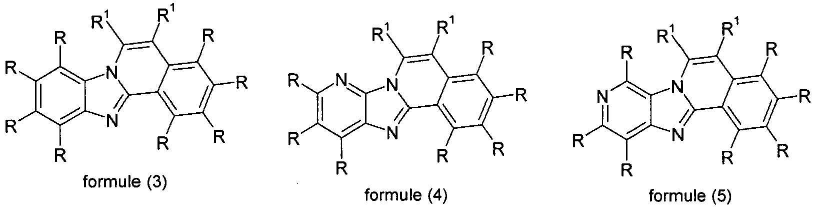 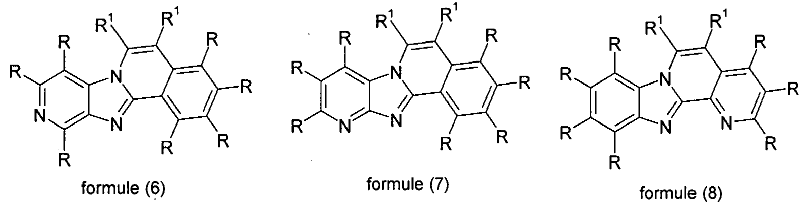 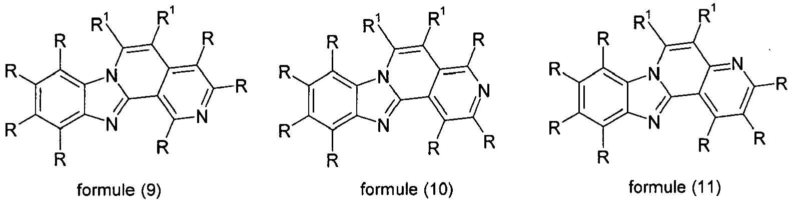 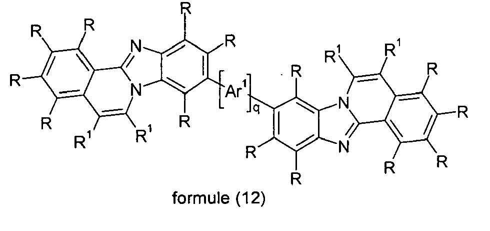 dans lesquelles les symboles et indices utilisés présentent les significations données selon la revendication 1.

4. Dispositif électroluminescent organique selon une ou plusieurs des revendications 1 à 3, **caractérisé en ce qu'**au moins un groupe R et/ou R¹ dans le composé de la formule (1) ou (2) n'est pas égal à H ou D.

5. Dispositif électroluminescent organique selon une ou plusieurs des revendications 1 à 4, **caractérisé en ce que** le composé de la formule (1) est choisi parmi les composés des formules (3a) à (3i) : 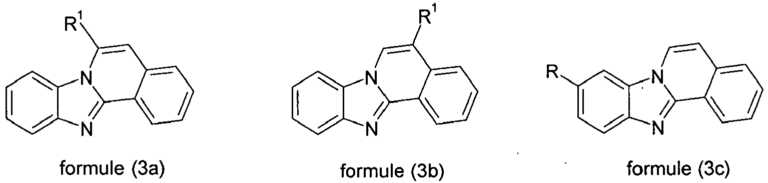 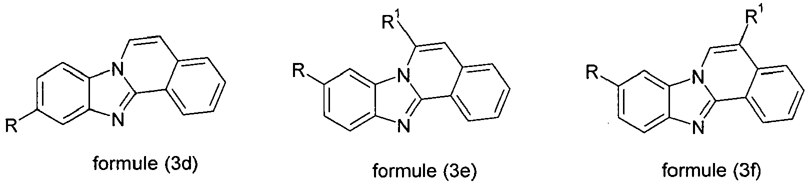 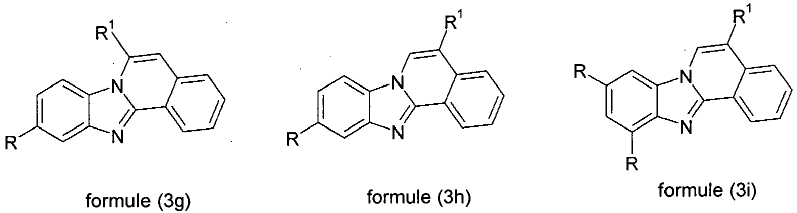 dans lesquelles les symboles utilisés présentent les significations données selon la revendication 1 et R et R¹ ne sont pas égaux à H ou D.

6. Dispositif électroluminescent organique selon une ou plusieurs des revendications 1 à 5, **caractérisé en ce que** R ou R¹ est choisi, pour chaque occurrence, de manière identique ou différente, parmi le groupe constitué par H, D, F, CN, N(Ar)₂, C(=O)Ar, P(=O)(Ar)₂, un groupe alkyle en chaîne droite comportant 1 à 10 atome(s) de C ou un groupe alkyle ramifié ou cyclique comportant 3 à 10 atomes de C ou un groupe alkényle comportant 2 à 10 atomes de C, dont chacun peut être substitué par un radical ou plusieurs radicaux R², où un ou plusieurs groupe(s) CH₂ non adjacents peut/peuvent être remplacé(s) par O ou S et où un ou plusieurs atome(s) de H peut/peuvent être remplacé(s) par D ou F, un système de cycle aromatique ou hétéroaromatique comportant 6 à 30 atomes de cycle aromatique, lequel peut, dans chaque cas, être substitué par un radical ou plusieurs radicaux R².

7. Dispositif électroluminescent organique selon une ou plusieurs des revendications 1 à 6, **caractérisé en ce qu'**au moins un substituant R et/ou R¹ est choisi parmi des structures des formules (13) à (17) : 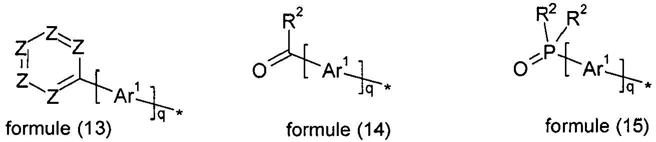 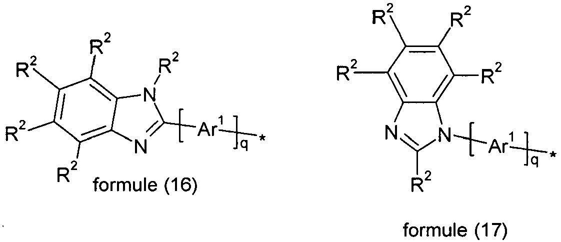 dans lesquelles les symboles et indices présentent les significations données selon la revendication 1, * indique la position de la liaison sur la structure de base de la formule (1) ou de la formule (2) et en outre :
Z est, pour chaque occurrence, de manière identique ou différente, CR² ou N, étant entendu qu'un seul groupe Z, deux groupes Z ou trois groupes Z représente/représentent N.

8. Dispositif électroluminescent organique selon la revendication 7, **caractérisé en ce qu'**au moins un substituant R ou R¹ est choisi parmi les groupes des formules (18) à (24) : 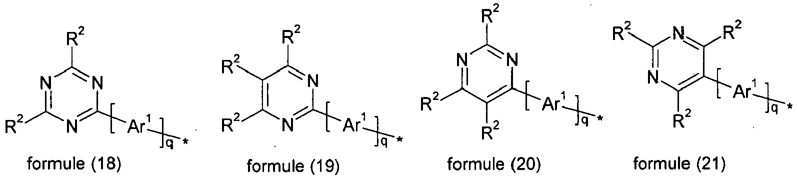 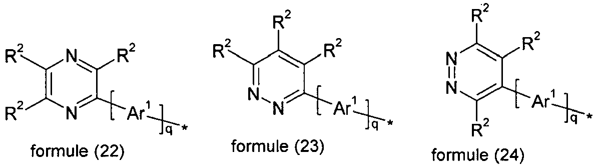 dans lesquelles les symboles et indices utilisés présentent les significations données selon la revendication 1.

9. Dispositif électroluminescent organique selon une ou plusieurs des revendications 1 à 8, **caractérisé en ce qu'**au moins un substituant R ou R¹ est choisi parmi le groupe constitué par -NAr₂, les dérivés de triarylamine, les dérivés de carbazole, les dérivés d'indénocarbazole, les dérivés d'indolocarbazole, les dérivés d'azacarbazole, les dérivés d'indole, les dérivés de furane, les dérivés de benzofurane, les dérivés de dibenzofurane, les dérivés de thiophène, les dérivés de benzothiophène et les dérivés de dibenzothiophène, dont chacun peut être substitué par un radical ou plusieurs radicaux R².

10. Dispositif électroluminescent organique selon la revendication 9, **caractérisé en ce qu'**au moins un substituant R ou R¹ est choisi parmi les groupes des formules (25) à (42) : 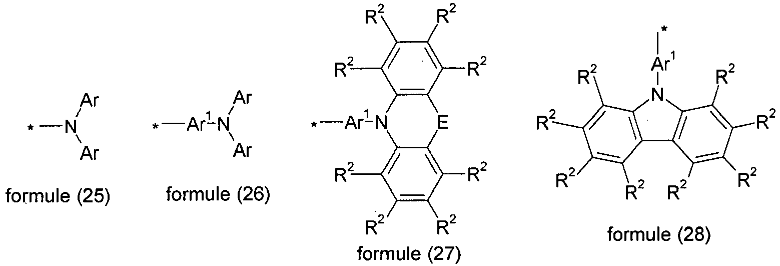 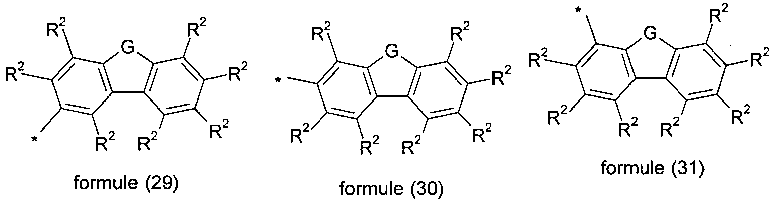 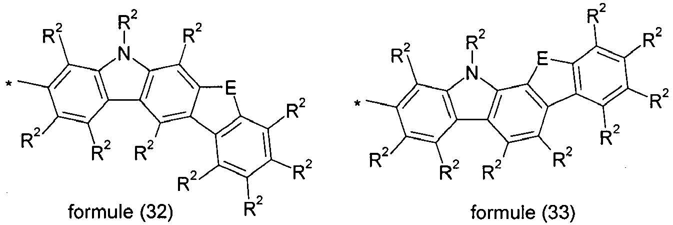 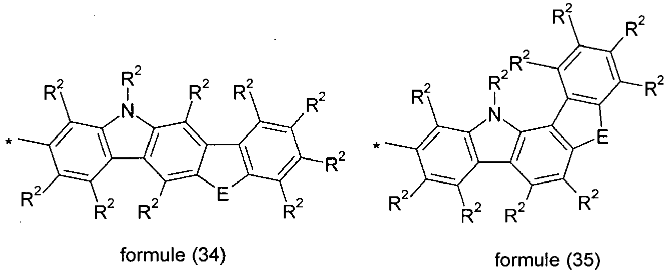 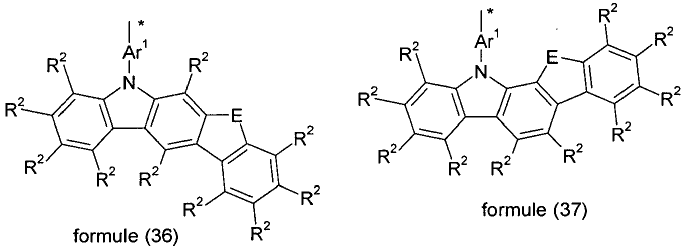 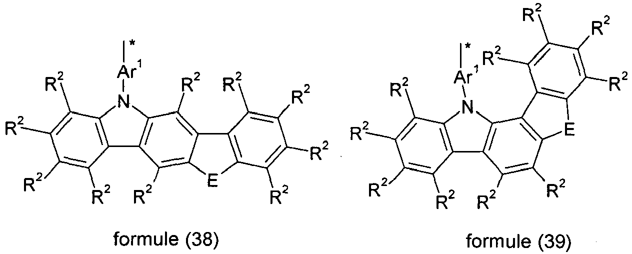 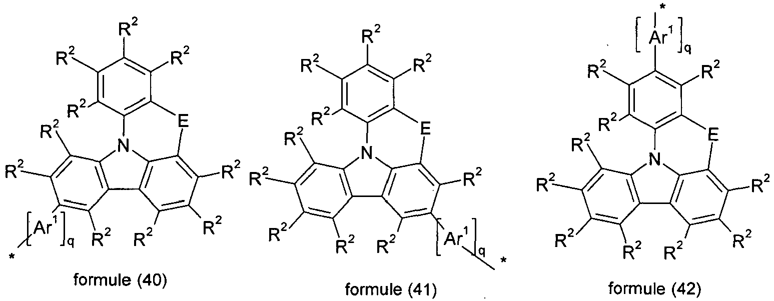 dans lesquelles les symboles utilisés présentent les significations données ci avant et en outre :
E est choisi parmi le groupe constitué par C(R²)₂, NR², O ou S ;
G est choisi parmi le groupe constitué par NR², O ou S.

11. Dispositif électroluminescent organique selon une ou plusieurs des revendications 1 à 10, **caractérisé en ce que** le composé de la formule (1) ou de la formule (2) est utilisé en tant que matériau de matrice pour un composé fluorescent ou phosphorescent, en particulier pour un composé phosphorescent, dans une couche d'émission et/ou **en ce que** le composé de la formule (1) ou de la formule (2) est utilisé en tant que matériau de transport d'électrons dans une couche de transport d'électrons ou d'injection d'électrons et/ou **en ce que** le composé de la formule (1) ou de la formule (2) est utilisé dans une couche de blocage de trous et/ou **en ce que** le composé de la formule (1) ou de la formule (2) est utilisé dans une couche de transport de trous ou dans une couche d'injection de trous ou dans une couche de blocage d'électrons ou dans une couche de blocage d'excitons.

12. Procédé pour la fabrication d'un dispositif électroluminescent organique selon une ou plusieurs des revendications 1 à 10, **caractérisé en ce qu'**au moins une couche est appliquée au moyen d'un processus de sublimation ou **en ce qu'**au moins une couche est appliquée au moyen du procédé OVPD (Dépôt Chimique en Phase Vapeur Organique) ou **en ce qu'**au moins une couche est appliquée à partir d'une solution ou au moyen d'un procédé d'impression.
